# EUROPEAN PATENT APPLICATION

(11) **EP 4 658 011 A1**
(43) Date of publication of application: **03.12.2025**
(21) Application number: 23941093.9
(22) Date of filing: 16.06.2023
(51) Int. Cl.: H10B 12/00, H01L 21/82, H01L 27/105

(54) **SEMICONDUCTOR STRUCTURE AND MANUFACTURING METHOD THEREFOR, MEMORY, AND MEMORY SYSTEM**

(71) Applicant: Yangtze Memory Technologies Co., Ltd., Wuhan, Hubei 430000 (CN)
(72) Inventor: LIU, Yaqin, Wuhan, Hubei 430000 (CN); LIU, Wei, Wuhan, Hubei 430000 (CN); CHEN, Liang, Wuhan, Hubei 430000 (CN); LIU, Zichen, Wuhan, Hubei 430000 (CN); WANG, Yanhong, Wuhan, Hubei 430000 (CN)
(74) Representative: Lippert Stachow Patentanwälte Rechtsanwälte
(86) International application number: PCT/CN2023/100754
(87) International publication number: WO 2024/254860

(57) **Abstract**

A semiconductor structure and a fabrication method thereof, a memory and a memory system are provided. The method includes: forming a plurality of capacitor holes penetrating through a first stack layer comprising a first region and a second region where the capacitor holes are located; forming a first electrode layer on inner walls of the capacitor holes; forming a dielectric layer in the first region and the second region; forming a second electrode layer on a side of the dielectric layer; removing the second electrode layer on the first stack layer in the second region; and forming a contact structure penetrating through the first stack layer in the second region. The method can prevent an etch loading effect from occurring in the first region during formation of the capacitor holes, which is favorable to form capacitor structures with a uniform size, thus improving reliability of the capacitor structures.

## Description

### TECHNICAL FIELD

The present application relates to the technical field of semiconductors, and particularly to a semiconductor structure and a fabrication method thereof, a memory and a memory system.

### BACKGROUND

A dynamic random access memory (DRAM) is a semiconductor memory device and consists of several duplicate memory cells. Each memory cell comprises a capacitor structure configured to store charges, and the capacitor structure affects storage capability of the DRAM.

The capacitor structure in the existing DRAM is typically located in a core area. However, a serious etch loading effect easily occurs during fabrication of capacitor holes of the core area, thus affecting reliability of the final capacitor structure.

### SUMMARY

The present application aims at providing a semiconductor structure and a fabrication method thereof, a memory and a memory system, which can effectively improve the etch loading effect of the core area during fabrication of capacitor holes and improve reliability of capacitor structures.

In an aspect, examples of the present application provide a fabrication method of a semiconductor structure, comprising:
forming a plurality of capacitor holes penetrating through a first stack layer along a stacking direction, wherein the first stack layer comprises a first region and a second region, and the capacitor holes are located in the first region and the second region;
forming a first electrode layer on inner walls of the capacitor holes;
forming a dielectric layer in the first region and the second region;
forming a second electrode layer on a side of the dielectric layer facing away from the first stack layer;
removing the second electrode layer on the first stack layer in the second region; and
forming a contact structure penetrating through the first stack layer in the second region along the stacking direction.

In another aspect, examples of the present application further provide another fabrication method of a semiconductor structure, comprising:
forming a plurality of capacitor holes penetrating through a first stack layer along a stacking direction, wherein the first stack layer comprises a first region and a second region, and the capacitor holes are located in the first region and the second region;
forming a first electrode layer on inner walls of the capacitor holes in the first region;
removing part of the first stack layer in the first region and the second region;
forming a dielectric layer and a second electrode layer in the first region, wherein the second electrode layer is located on a side of the dielectric layer facing away from the first electrode layer;
forming a planar layer in the second region; and
forming a contact structure penetrating through the planar layer along the stacking direction.

In another aspect, examples of the present application further provide another fabrication method of a semiconductor structure, comprising:
forming a plurality of capacitor holes penetrating through a first stack layer along a stacking direction, wherein the first stack layer comprises a first region and a second region, and the capacitor holes are located in the first region and the second region;
forming a first electrode layer on inner walls of the capacitor holes in the first region and the second region;
forming a dielectric layer on a side of the first stack layer in the first region and the second region, wherein the dielectric layer covers a side of the first electrode layer facing away from the inner walls of the capacitor holes;
forming a second electrode layer on a side of the dielectric layer in the first region facing away from the first electrode layer;
removing the first stack layer, the dielectric layer and the first electrode layer in the second region;
forming a planar layer in the second region; and
forming a contact structure penetrating through the planar layer along the stacking direction.

In another aspect, examples of the present application further provide a semiconductor structure, comprising:
a first stack structure comprising a first region and a second region;
a first electrode layer in the first region and the second region, wherein the first electrode layer penetrates through the first stack structure along a stacking direction, and the first electrode layer in the first region and the first electrode layer in the second region are disposed as being spaced apart;
a dielectric layer in the first region and the second region;
a second electrode layer in the first region and the second region, wherein the dielectric layer is disposed between the first electrode layer and the second electrode layer, and the second electrode layer in the first region and the second electrode layer in the second region are disposed as being spaced apart; and
a contact structure penetrating through the first stack structure in the second region along the stacking direction.

In another aspect, examples of the present application further provide a memory, comprising: the semiconductor structure of any one of the above examples, and a peripheral circuit structure, wherein the peripheral circuit structure is connected with the semiconductor structure.

In another aspect, examples of the present application further provide a memory system, comprising: at least one of above-mentioned memories, and a controller coupled with the memory and configured to control the memory to store data.

According to the semiconductor structure and the fabrication method thereof, the memory and the memory system provided by the examples of the present application, the plurality of capacitor holes penetrating through the first stack layer along the stacking direction are formed, the first stack layer comprises the first region and the second region, and the capacitor holes are located in the first region and the second region, such that the serious etch loading effect can be greatly avoided in the first region during the formation of the capacitor holes, the size consistency of the capacitor holes in the first region is ensured as much as possible, and under-etching will not occur. Subsequently, the first electrode layer is formed on the inner walls of the capacitor holes; the dielectric layer is formed in the first region and the second region; the second electrode layer is formed on the side of the dielectric layer facing away from the first stack layer; the second electrode layer on the first stack layer in the second region is removed; and the contact structure penetrating through the first stack layer in the second region along the stacking direction is formed, such that the capacitor structures with a uniform size can be formed in the first region, thus improving reliability of the capacitor structures.

### BRIEF DESCRIPTION OF THE DRAWINGS

In order to illustrate the technical solutions in examples of the present application more clearly, the drawings to be used in description of the examples will be briefly introduced below. Apparently, the drawings described below are only some examples of the present application. Those skilled in the art may obtain other drawings according to these drawings without creative work.
FIG. 1 is a flow diagram of a fabrication method of a semiconductor structure provided by examples of the present application;
FIGs. 2A to 2F are schematic cross-sectional structure views of a semiconductor structure in different process operations provided by examples of the present application;
FIG. 3A is a schematic cross-sectional structure view along a C1-C1 line in FIG. 2A;
FIG. 3B is a schematic cross-sectional structure view along a C2-C2 line in FIG. 2B;
FIG. 3C is a schematic cross-sectional structure view along a C3-C3 line in FIG. 2C;
FIG. 3D is a schematic cross-sectional structure view along a C4-C4 line in FIG. 2D;
FIG. 3E is a schematic cross-sectional structure view along a C5-C5 line in FIG. 2F;
FIG. 4A is a schematic cross-sectional structure view of another semiconductor structure provided by examples of the present application;
FIG. 4B is a schematic cross-sectional structure view along a d-d line in FIG. 4A;
FIGs. 5A to 5F are another schematic cross-sectional structure views of a semiconductor structure in different process operations provided by examples of the present application;
FIG. 6A is a schematic cross-sectional structure view along a D1-D1 line in FIG. 5A;
FIG. 6B is a schematic cross-sectional structure view along a D2-D2 line in FIG. 5B;
FIG. 6C is a schematic cross-sectional structure view along a D3-D3 line in FIG. 5C;
FIG. 6D is a schematic cross-sectional structure view along a D4-D4 line in FIG. 5D;
FIG. 6E is a schematic cross-sectional structure view along a D5-D5 line in FIG. 5F;
FIGs. 7A to 7E are yet another schematic cross-sectional structure views of a semiconductor structure in different process operations provided by examples of the present application;
FIG. 7F is a schematic structure view of a memory provided by examples of the present application;
FIG. 8A is a schematic cross-sectional structure view along an E1-E1 line in FIG. 7A;
FIG. 8B is a schematic cross-sectional structure view along an E2-E2 line in FIG. 7B;
FIG. 8C is a schematic cross-sectional structure view along an E3-E3 line in FIG. 7C;
FIG. 8D is a schematic cross-sectional structure view along an E4-E4 line in FIG. 7E;
FIGs. 9A to 9J are schematic cross-sectional structure views of another semiconductor structure in different process operations provided by examples of the present application;
FIG. 10A is a schematic cross-sectional structure view along an F1-F1 line in FIG. 9A;
FIG. 10B is a schematic cross-sectional structure view along an F2-F2 line in FIG. 9B;
FIG. 10C is a schematic cross-sectional structure view along an F3-F3 line in FIG. 9C;
FIG. 10D is a schematic cross-sectional structure view along an F4-F4 line in FIG. 9D;
FIG. 10E is a schematic cross-sectional structure view along an F5-F5 line in FIG. 9E;
FIG. 10F is a schematic cross-sectional structure view along an F6-F6 line in FIG. 9F;
FIG. 10G is a schematic cross-sectional structure view along an F7-F7 line in FIG. 9G;
FIG. 10H is a schematic cross-sectional structure view along an F8-F8 line in FIG. 9H;
FIG. 10I is a schematic cross-sectional structure view along an F9-F9 line in FIG. 9I;
FIG. 10J is a schematic cross-sectional structure view along an F10-F10 line in FIG. 9J;
FIGs. 11A to 11E are another schematic cross-sectional structure views of another semiconductor structure in different process operations provided by examples of the present application;
FIG. 11F is a schematic structure view of a memory provided by examples of the present application;
FIG. 12A is a schematic cross-sectional structure view along a G1-G1 line in FIG. 11A;
FIG. 12B is a schematic cross-sectional structure view along a G2-G2 line in FIG. 11B;
FIG. 12C is a schematic cross-sectional structure view along a G3-G3 line in FIG. 11C;
FIG. 12D is a schematic cross-sectional structure view along a G4-G4 line in FIG. 11D;
FIG. 12E is a schematic cross-sectional structure view along a G5-G5 line in FIG. 11E;
FIG. 13 is a flow diagram of a fabrication method of yet another semiconductor structure provided by examples of the present application;
FIGs. 14A to 14H are schematic cross-sectional structure views of yet another semiconductor structure in different process operations provided by examples of the present application;
FIG. 14I is a schematic structure view of a memory provided by examples of the present application;
FIG. 15A is a schematic cross-sectional structure view along an H1-H1 line in FIG. 14A;
FIG. 15B is a schematic cross-sectional structure view along an H2-H2 line in FIG. 14B;
FIG. 15C is a schematic cross-sectional structure view along an H3-H3 line in FIG. 14C;
FIG. 15D is a schematic cross-sectional structure view along an H4-H4 line in FIG. 14D;
FIG. 15E is a schematic cross-sectional structure view along an H5-H5 line in FIG. 14E;
FIG. 15F is a schematic cross-sectional structure view along an H6-H6 line in FIG. 14F;
FIG. 15G is a schematic cross-sectional structure view along an H7-H7 line in FIG. 14G;
FIG. 15H is a schematic cross-sectional structure view along an H8-H8 line in FIG. 14H;
FIG. 16 is a schematic structure view of a system provided by examples of the present application.

### DETAILED DESCRIPTION

The present application will be described below in detail in conjunction with the accompanying drawings and examples. It is particularly pointed out that, examples below are only used to illustrate the present application, rather than to restrict the scope of the present application. Likewise, the examples below are merely part but not all of examples of the present application. All other examples obtained by those skilled in the art without creative work shall fall in the protection scope of the present application.

In the description herein, it is to be understood that the terms "center", "lateral", "upper", "lower", "left", "right", "vertical", "horizontal", "top", "bottom", "inner", "outer", etc. indicate orientation or position relationships that are based on the orientations or position relationships as shown in the drawings, which are only intended to facilitate description of the present application and to simplify the description, instead of indicating or implying the device or element indicated must have a specific orientation and be configured and operated in a specific orientation, and thus cannot be understood as limitations on the present application. Furthermore, the terms "first" and "second" are only for the purpose of description, and cannot be construed as indicating or implying relative importance or implicitly indicating the number of indicated technical features. Thus, features defined by "first" and "second" may explicitly or implicitly include one or more of the features.

In the description herein, it is to be noted that, unless otherwise specified and defined expressly, the terms "mounted", "linked" and "connected" should be understood broadly, which, for example, may be fixed connection, detachable connection, or integrated connection; may be either mechanical connection or electrical connection; may be either direct connection or indirect connection through intermediate media, and may be communication inside two elements. Those of ordinary skill in the art may understand the specific meanings of the above terms in the present application according to specific conditions.

It is to be understood that the meaning of "on", "over" and "above" in the description herein should be interpreted in the broadest manner, such that "on" not only represents the meaning of "on" something without an intermediate feature or a layer therebetween (i.e., directly on something) but also includes the meaning of "on" something with an intermediate feature or a layer therebetween.

The terms as used herein are only used to describe the specific implementations, and are not intended to limit the exemplary implementations. Unless otherwise indicated expressly in the context, the singular forms "a" and "an" used herein are also intended to include plurality. "A plurality of" means two or more. It should be also understood that the terms "comprise" and/or "include", as used herein, specify the presence of the stated features, integers, steps, operations, units and/or components, and do not preclude the presence or addition of one or more of other features, integers, steps, operations, units, components, and/or a combination thereof.

Examples of the present application provide a semiconductor structure and a fabrication method thereof, a memory and a memory system.

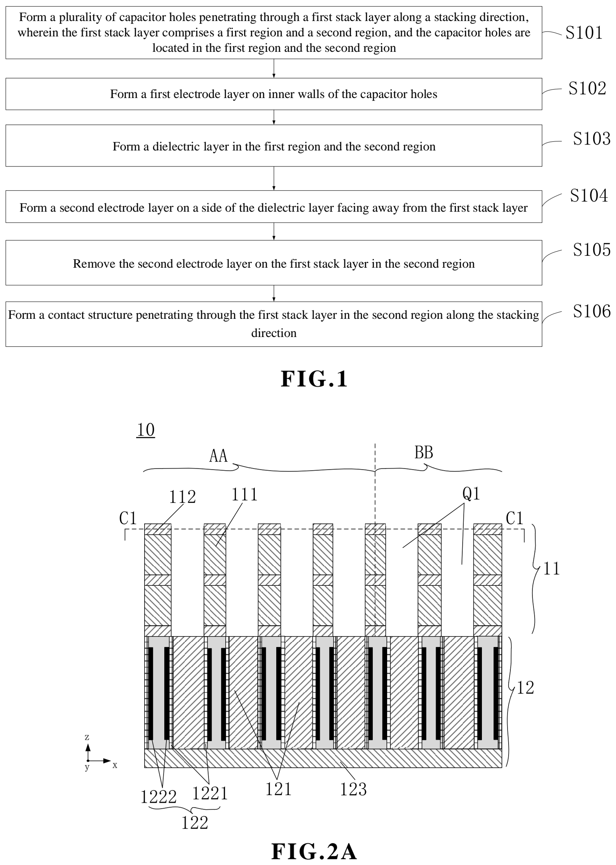

Referring to FIG. 1, FIG. 1 is a flow diagram of a fabrication method of a semiconductor structure provided by examples of the present application, and the fabrication method of the semiconductor structure may comprise the following operations S101-S106:
operation S101: forming a plurality of capacitor holes penetrating through a first stack layer along a stacking direction, wherein the first stack layer comprises a first region and a second region, and the capacitor holes are located in the first region and the second region;
operation S102: forming a first electrode layer on inner walls of the capacitor holes;
operation S103: forming a dielectric layer in the first region and the second region;
operation S104: forming a second electrode layer on a side of the dielectric layer facing away from the first stack layer;
operation S105: removing the second electrode layer on the first stack layer in the second region; and
operation S106: forming a contact structure penetrating through the first stack layer in the second region along the stacking direction.

It should be understood that, the operations illustrated in the above fabrication method are not exclusive, and other operations can also be performed before, after, or between any of the illustrated operations.

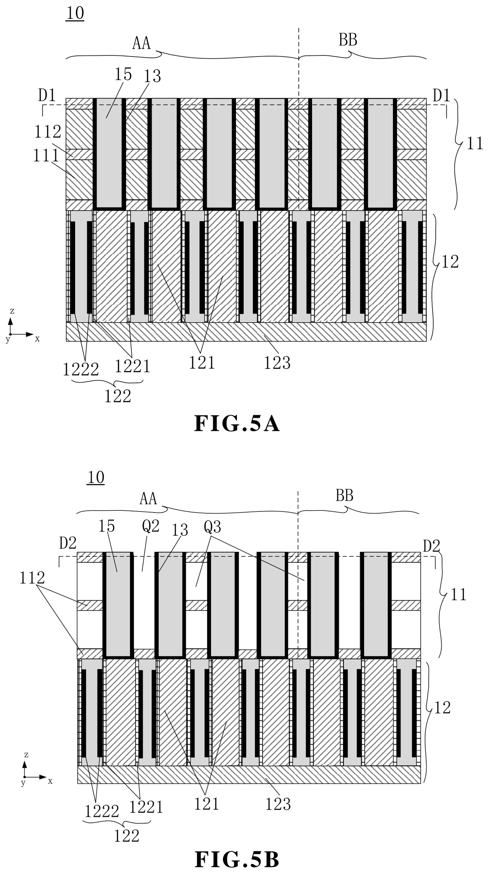

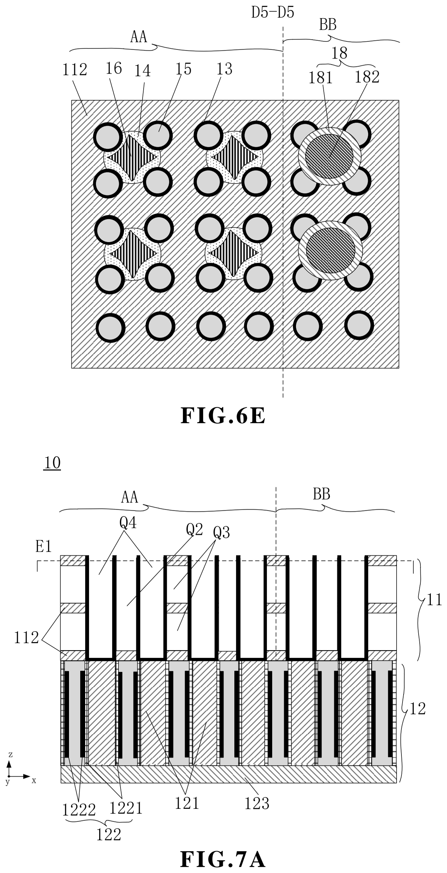

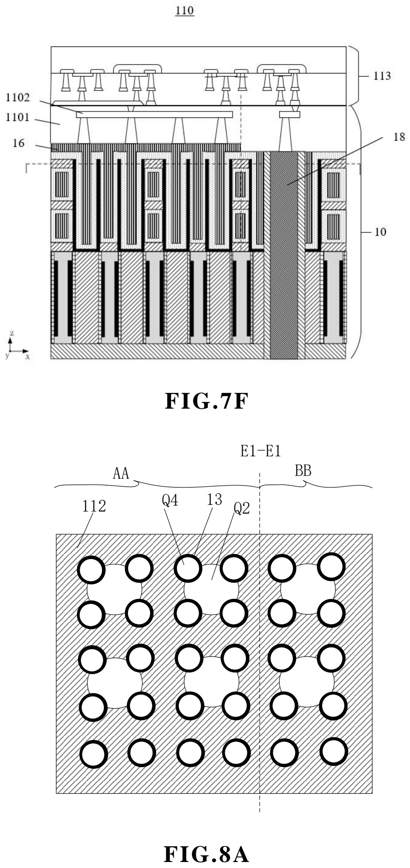

Referring to FIGs. 2A to 2F, 5A to 5F, and 7A to 7E, FIGs. 2A to 2F are schematic cross-sectional structure views of a semiconductor structure 10 in different process operations provided by examples of the present application, FIGs. 5A to 5F are another schematic cross-sectional structure views of a semiconductor structure 10 in different process operations provided by examples of the present application, and FIGs. 7A to 7E are yet another schematic cross-sectional structure views of a semiconductor structure 10 in different process operations provided by examples of the present application. The semiconductor structure 10 may comprise a cup capacitor structure, a pillar capacitor structure or a cylindrical capacitor structure. The above operations S101-S106 will be further described below in conjunction with FIGs. 2A to 2F, 5A to 5F, and 7A to 7E:

Operation S101: forming a plurality of capacitor holes Q1 penetrating through a first stack layer 11 along a stacking direction z, wherein the first stack layer 11 comprises a first region AA and a second region BB, and the capacitor holes Q1 are located in the first region AA and the second region BB.

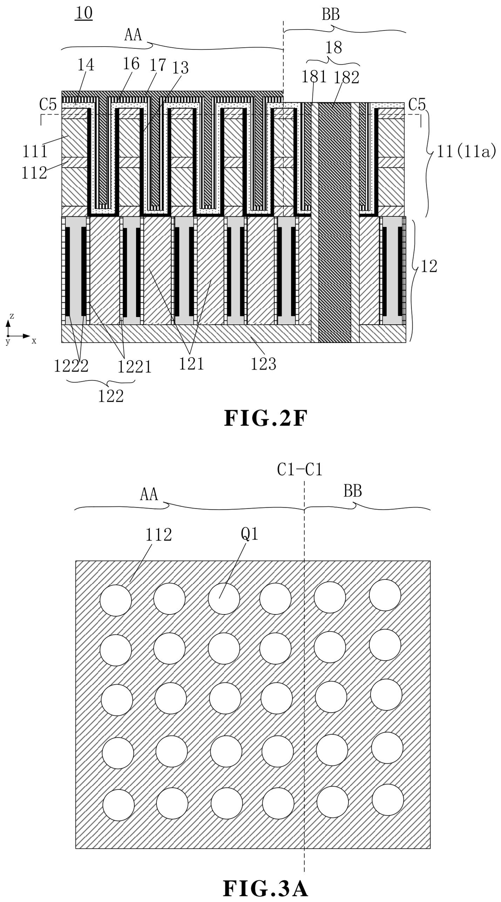

If the semiconductor structure 10 comprises the cup capacitor structure, the pillar capacitor structure or the cylindrical capacitor structure, referring to FIGs. 2A to 3A above, FIG. 3A is a schematic cross-sectional structure view along a C1-C1 line in FIG. 2A. The first region AA is a region corresponding to a memory array, the second region BB is another region, and the first region AA may adjoin the second region BB, for example, the second region BB is disposed around the first region AA. The capacitor holes Q1 may be distributed throughout the regions of the first stack layer 11, and interior portions of the capacitor holes Q1 are disposed as being spaced apart. In an example, these capacitor holes Q1 may be set to have the same size and the same spacing.

In an example, the first stack layer 11 may be formed using a thin film deposition process, such as chemical vapor deposition (CVD), physical vapor deposition (PVD), atomic layer deposition (ALD) or any combination thereof. The first stack layer 11 may be formed by alternately stacking film layers of different insulation materials, for example, formed by alternately stacking film layers of silicon dioxide and silicon nitride.

The capacitor holes Q1 may be formed in both the first region AA and the second region BB of the first stack layer 11 through two patterning processes that are orthogonal or at a certain angle. At this point, patterns of the capacitor holes Q1 are distributed throughout a surface of the first stack layer 11 relatively uniformly, that is, density difference of etching patterns corresponding to the first region AA and the second region BB is small, so differences in etching depths and sizes of the capacitor holes Q1 finally formed in the first region AA and the second region BB are relatively small, which can avoid a serious etch loading effect as much as possible. Moreover, even if there is a certain etch loading effect which affects the etching depths and the hole sizes of the capacitor holes Q1 at an edge, the etch loading effect may generally only affect the outermost capacitor holes Q1 in the second region BB, and it is unlikely to affect the capacitor holes Q1 in the first region AA since the second region BB is typically disposed around the first region AA. Therefore, such a fabrication method of forming the capacitor holes Q1 in both the first region AA and the second region BB can greatly prevent the serious etch loading effect from occurring in the first region AA, so as to ensure the consistency of the etching depths and the sizes of the capacitor holes Q1 in the first region AA as much as possible, and avoid insufficient etching depths or too small sizes of part of the capacitor holes Q1.

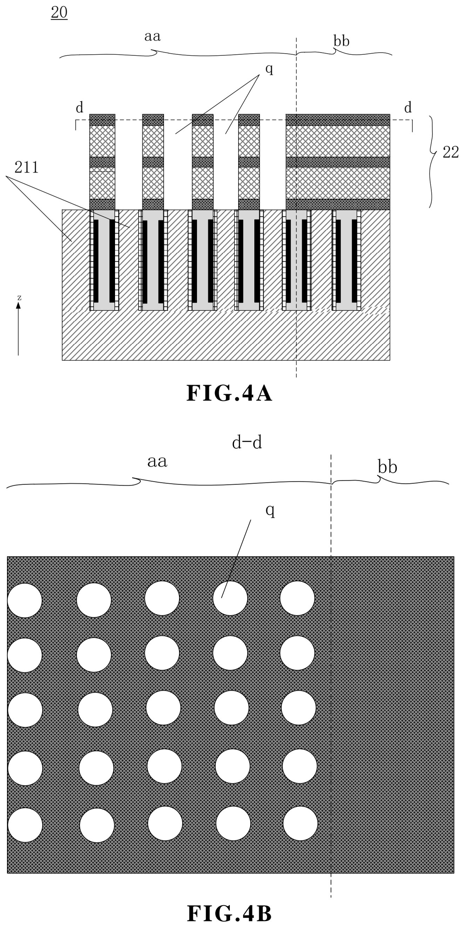

However, in other implementations, referring to FIGs. 4A and 4B, FIG. 4A illustrates a schematic cross-sectional structure of another semiconductor structure 20 provided by examples of the present application, and FIG. 4B is a schematic cross-sectional structure view along a d-d line in FIG. 4A. The semiconductor structure 20 comprises a first stack structure 21, and a second stack layer 22 on the first stack structure 21. The first stack structure 21 comprises channel structures 211, the second stack layer 22 comprises a core area aa and a non-core area bb, and capacitor holes q are formed in the core area aa. In an example, the capacitor holes q may be directly formed in the core area aa, and then, a first electrode layer, a dielectric layer and a second electrode layer are fabricated, to obtain a capacitor structure located in the core area aa. However, during the fabrication of the capacitor holes q, the capacitor holes q are not required to be formed in the non-core area bb, that is, density difference of etching patterns of the core area aa and the non-core area bb is large, so the capacitor holes q at the boundary of the core area aa and the non-core area bb may undergo a serious etch loading effect, such that the capacitor holes q at an edge of the core area and the capacitor holes q in the middle of the core area aa have obvious differences in their etching depths and hole sizes. For example, the etching depths of the capacitor holes q at the edge of the core area aa are shallow such that the capacitor holes q cannot penetrate through the second stack layer 22 along a stacking direction z, which causes the capacitor structure finally formed at the edge of the core area aa to fail to be connected with the channel structures 211, or the sizes of the capacitor holes q are too small such that it affects the subsequent formation of the capacitor structure, thus affecting reliability of the capacitor structure. However, the semiconductor structure 10 provided by the examples of the present application at least partially solves the above technical problems.

It is to be noted that, in the semiconductor structure 10 provided by the examples of the present application, the capacitor structure may be formed after the formation of channel structures, that is, with continued reference to FIGs. 2A and 3A, before operation S101 above, the fabrication method may further comprise:
forming a second stack structure 12, wherein the second stack structure 12 comprises a plurality of channel structures 121 disposed as being spaced apart along a first direction x and a second direction y and gate structures 122 that extend along the second direction y and are connected with the plurality of channel structures 121, each of the gate structures 122 is located between two adjacent ones of the channel structures 121, and the first direction x, the second direction y and the stacking direction z are perpendicular to one another; and
forming the first stack layer 11 on the second stack structure 12.

Positions of the channel structures 121 at least correspond to positions of the capacitor holes Q1 in the first region AA. The first direction x and the second direction y may be an extending direction of the first stack layer 11. The first direction x, the second direction y and the stacking direction z of the first stack layer 11 are perpendicular to one another. The gate structure 122 may comprise a gate spacing layer 1221 and a gate layer 1222, wherein a material of the gate spacing layer 1221 may include an insulation material such as oxide, and a material of the gate layer 1222 may select any one or any combination of tungsten, cobalt, copper, aluminum, or polysilicon, and doped crystalline silicon.

In some implementations, the channel structures 121 are formed on a substrate that may include at least one of monocrystalline silicon (Si), monocrystalline germanium (Ge), a group III-V compound semiconductor material, a group II-VI compound semiconductor material or other semiconductor materials known in the art. In an example, first, the substrate is etched to form a plurality of active portions extending along the first direction x and disposed as being spaced apart along the second direction y on the substrate. Then, the gate structures 122 extending along the second direction y and at least connected with the active portions corresponding to the first region AA are formed, and the gate structures 122 penetrate through the active portions along the stacking direction z to obtain the channel structures 121.

In some implementations, an insulation material may be further filled between the gate structures 122 that are adjacent along the first direction x for isolation, to achieve electrical insulation between adjacent ones of the gate structures 122. After the filling of the insulation material, the substrate outside the channel structures 121 (i.e., the bottom substrate) may be removed, and a bit line 123 is fabricated and is connected with the channel structures 121.

In some implementations, the positions of the channel structures 121 may only correspond to the positions of the capacitor holes Q1 in the first region AA. Meanwhile, positions of the gate structures 122 only correspond to the first region AA, that is, the second stack structure 12 may comprise a core area corresponding to the first region AA and a non-core area corresponding to the second region BB, and the channel structures 121 and the gate structures 122 may be only located in the core area. In other implementations, the positions of the channel structures 121 may also correspond to positions of the capacitor holes Q1 in the second region BB. Meanwhile, the positions of the gate structures 122 may at least correspond to the first region AA, that is, the channel structures 121 may be located in the core area and the non-core area (for example, with continued reference to FIG. 2A), and the gate structures 122 may be located in the core area and the non-core area, or be only located in the core area, which is not limited here.

Operation S102: forming a first electrode layer 13 on inner walls of the capacitor holes Q1.

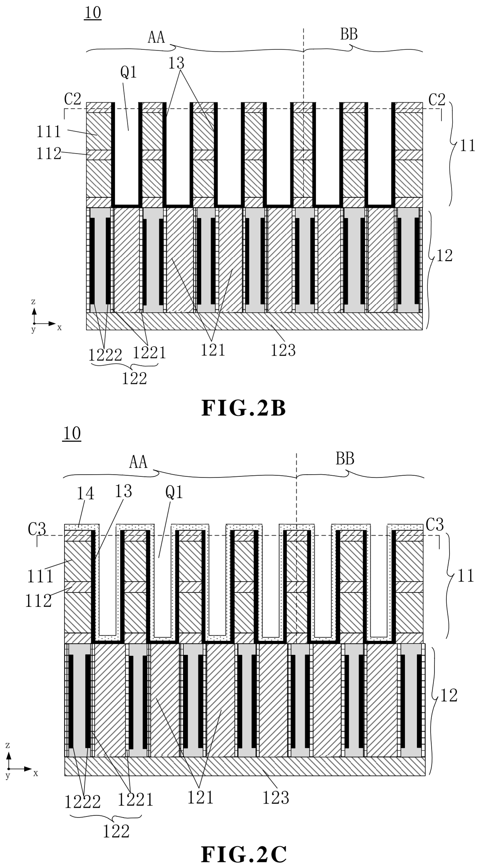

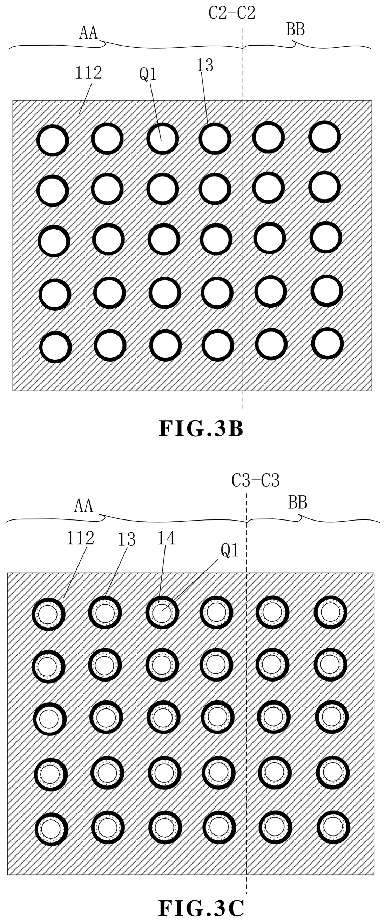

If the semiconductor structure 10 comprises the cup capacitor structure, the pillar capacitor structure or the cylindrical capacitor structure, with continued reference to FIGs. 2A, 2B and 3B, FIG. 3B is a schematic cross-sectional structure view along a C2-C2 line in FIG. 2B. A material of the first electrode layer 13 includes a conductive material such as a metal or a metal compound, for example, tungsten, copper, titanium nitride (TiN), etc. First, a layer of conductive material may be formed on a side of the first stack layer 11. Thereafter, the conductive material outside the capacitor holes Q1 is removed to form the first electrode layer 13 within the capacitor holes Q1.

It is to be noted that, since the capacitor holes Q1 are disposed as being spaced apart in the first region AA and the second region BB, interior portions of the first electrode layer 13 in the first region AA and interior portions of the first electrode layer 13 in the second region BB are also disposed as being spaced apart, that is, the first electrode layer 13 in the first region AA and the first electrode layer 13 in the second region BB each comprises a plurality of partitioned portions that are not connected with each other.

Operation S103: forming a dielectric layer 14 in the first region AA and the second region BB.

A material of the dielectric layer 14 includes a material with a high dielectric constant, and the dielectric layer 14 may be formed using a thin film deposition process. For different types of the capacitor structures, positions of the formation of the dielectric layer 14 are different.

In some implementations, for example, if the semiconductor structure 10 comprises the cup capacitor structure, with continued reference to FIGs. 2B, 2C and 3C, FIG. 3C is a schematic cross-sectional structure view along a C3-C3 line in FIG. 2C. In an example, for the cup capacitor structure, after the formation of the first electrode layer 13, the dielectric layer 14 may be formed directly. At this point, operation S103 above comprises: forming the dielectric layer 14 on a side of the first stack layer 11 in the first region AA and the second region BB, wherein the dielectric layer 14 covers a side of the first electrode layer 13 facing away from inner walls of the capacitor holes Q1. The dielectric layer 14 not only covers the first electrode layer 13 in the capacitor holes Q1, but also covers a top surface of the first stack layer 11.

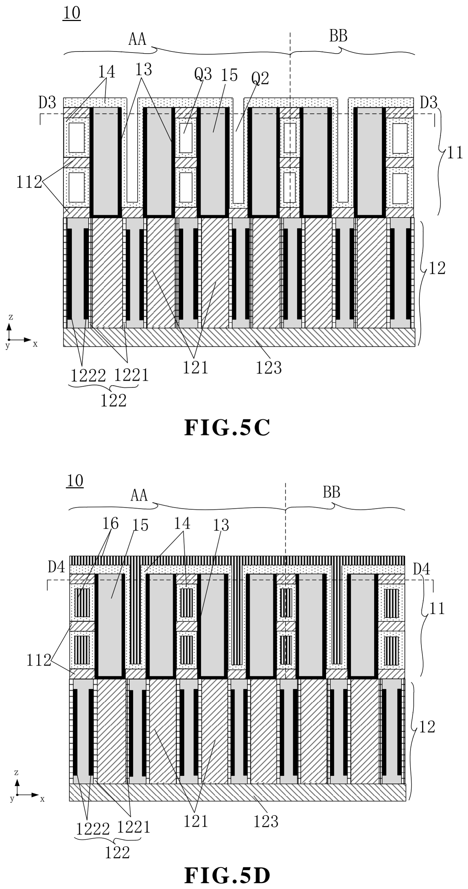

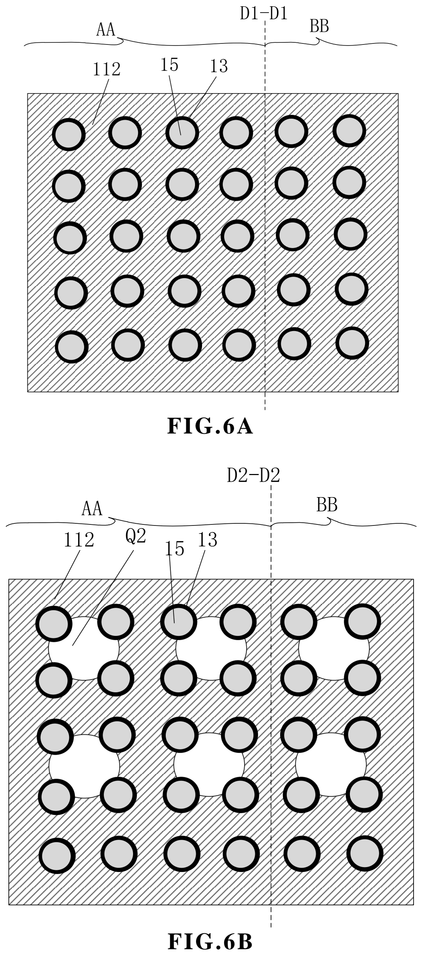

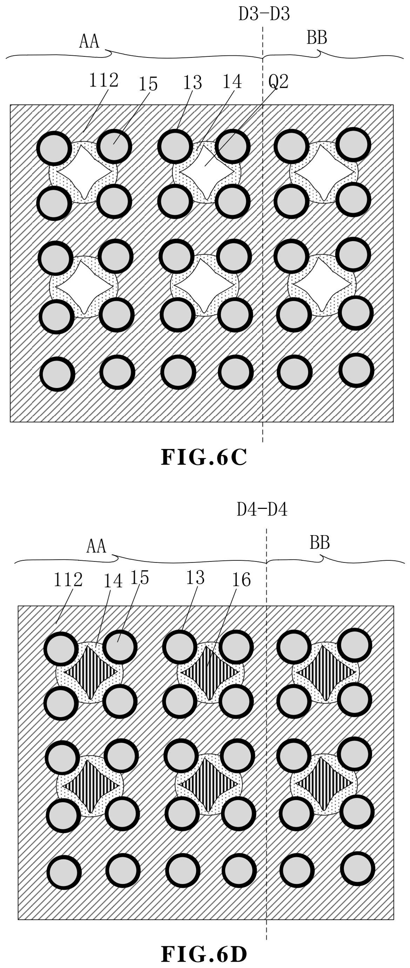

In some implementations, for example, if the semiconductor structure 10 comprises the pillar capacitor structure, referring to FIGs. 5A to 5F, FIGs. 5A to 5F are another schematic cross-sectional structure views of the semiconductor structure 10 in different process operations provided by examples of the present application. With continued reference to FIGs. 2B, 5A to 5C, and 6A to 6C, FIG. 6A is a schematic cross-sectional structure view along a D1-D1 line in FIG. 5A, FIG. 6B is a schematic cross-sectional structure view along a D2-D2 line in FIG. 5B, and FIG. 6C is a schematic cross-sectional structure view along a D3-D3 line in FIG. 5C. In an example, for the pillar capacitor structure, after the formation of the first electrode layer 13, first, part of the first stack layer 11 needs to be removed; and then, the dielectric layer 14 is formed. That is, the first stack layer 11 may comprise sacrificial layers 111. Before the above operation S103, the fabrication method further comprises:
forming a filling layer 15 on a side of the first electrode layer 13 facing away from the inner walls of the capacitor holes Q1, wherein the filling layer 15 fills the capacitor holes Q1; and
forming a plurality of spacing holes Q2 penetrating through part of the first stack layer 11 along the stacking direction z, and removing the sacrificial layers 111 to form first empty slots Q3, wherein the spacing holes Q2 are located in the first region AA and the second region BB.

The first stack layer 11 may comprise the sacrificial layers 111 and spacing layers 112 that are disposed alternately. A material of the sacrificial layers 111 may include silicon dioxide, and a material of the spacing layer 112 may include silicon nitride. A material of the filling layer 15 is generally different from the material of the first stack layer 11, for example, the material of the filling layer 15 may include carbon. After part of the first stack layer 11 is removed, the dielectric layer 14 is then formed, and the dielectric layer 14 may be located on the first stack layer 11, and fills the first empty slots Q3 and the spacing holes Q2.

In an example, the spacing holes Q2 may be formed by multiple times of etching. For example, first, a hole pattern corresponding to the spacing holes Q2 is formed on the spacing layer 112 through a mask; then, the sacrificial layer 111 is removed by wet etching or dry etching via the hole pattern, and the adjacent spacing layer 112 below is exposed; next, the exposed spacing hole 112 is etched down continuously to further expose the adjacent sacrificial layer 111 below; and next, the sacrificial layer 111 is removed via exposed positions of the sacrificial layer 111. All the sacrificial layers 111 within the first stack layer 11 are removed by multiple times of etching, thereby obtaining the spacing holes Q2 penetrating through part of the first stack layer 11 along the stacking direction z.

It is to be noted that, only one cross-sectional shape (circle as shown in the figures) and arrangement of the spacing holes Q2 is illustrated in the figures. In other implementations, the spacing holes Q2 may comprise other cross-sectional shapes (for example, trapezoid) and arrangements, which is not limited here. In other implementations, in addition to the above-mentioned multiple times of etching, the spacing holes Q2 may be formed by other means, for example, one time of etching, which is not limited here.

Meanwhile, during the formation of the spacing holes Q2, the sacrificial layers 111 are removed together to obtain the first empty slots Q3. After the spacing holes Q2 and the first empty slots Q3 are formed, the dielectric layer 14 is then formed (i.e., the above operation S103 is then performed). At this point, the dielectric layer 14 not only covers the top surface of the first stack layer 11, but also covers inner walls of the first empty slots Q3 and inner walls of the spacing holes Q2. However, during the removal of the sacrificial layers 111 in the first stack layer 11, since the capacitor holes Q1 are filled with the filling layer 15, the first stack layer 11 will not collapse under support of the filling layer 15.

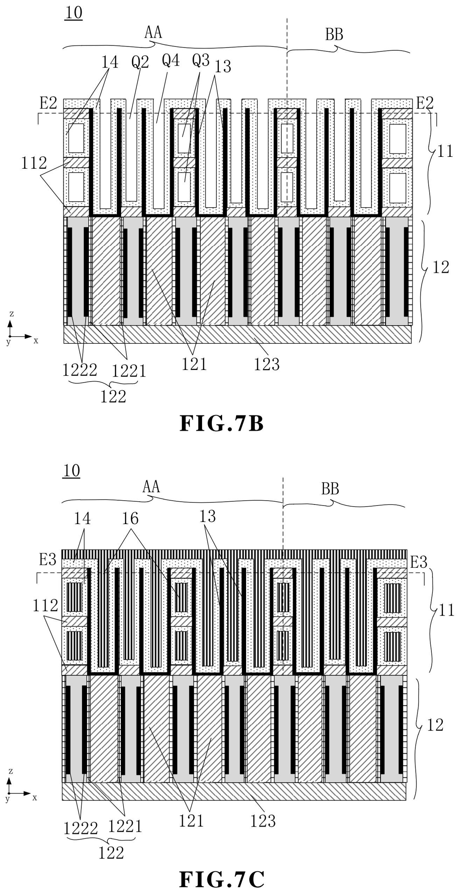

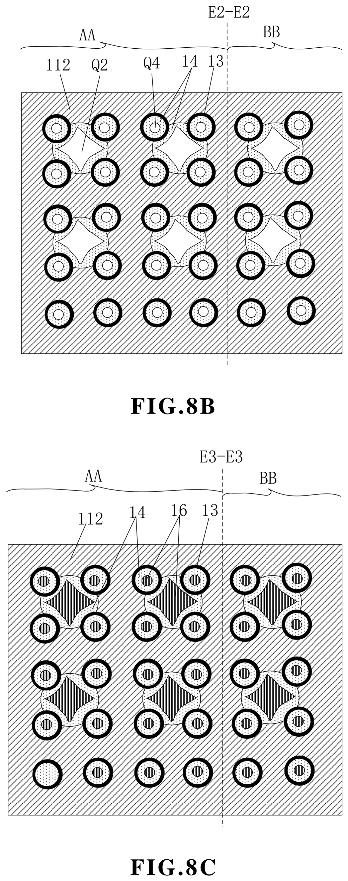

In some implementations, for example, if the semiconductor structure 10 comprises the cylindrical capacitor structure, referring to FIGs. 7A to 7E, FIGs. 7A to 7E are yet another schematic cross-sectional structure views of the semiconductor structure 10 in different process operations provided by examples of the present application. With continued reference to FIGs. 5B, 7A and 7B, and 8A and 8B above, FIG. 8A is a schematic cross-sectional structure view along an E1-E1 line in FIG. 7A, and FIG. 8B is a schematic cross-sectional structure view along an E2-E2 line in FIG. 7B. In an example, for the cylindrical capacitor structure, similar to the pillar capacitor structure, before the formation of the dielectric layer 14, part of the first stack layer 11 needs to be removed first; and for the cylindrical capacitor structure, the filling layer 15 needs to be further removed. That is, the above operation "forming the plurality of spacing holes Q2 penetrating through part of the first stack layer 11 along the stacking direction z and removing the sacrificial layers 111 to form the first empty slots Q3" further comprises:
removing the filling layer 15 to form second empty slots Q4,
wherein the filling layer 15 may be removed through dry or wet etching. During subsequent formation of the dielectric layer 14, different from the above pillar capacitor structure, the dielectric layer 14 is also located in the second empty slots Q4 in addition to the first empty slots Q3 and the spacing holes Q2.

Operation S104: forming a second electrode layer 16 on a side of the dielectric layer 14 facing away from the first stack layer 11.

A material of the second electrode layer 16 mainly includes a conductive material, which may be selected from any one or any combination of tungsten, cobalt, copper, aluminum, or polysilicon, and doped crystalline silicon. The second electrode layer 16 is located in the first region AA and the second region BB, and for different types of capacitor structures, positions of formation of the second electrode layer 16 are different.

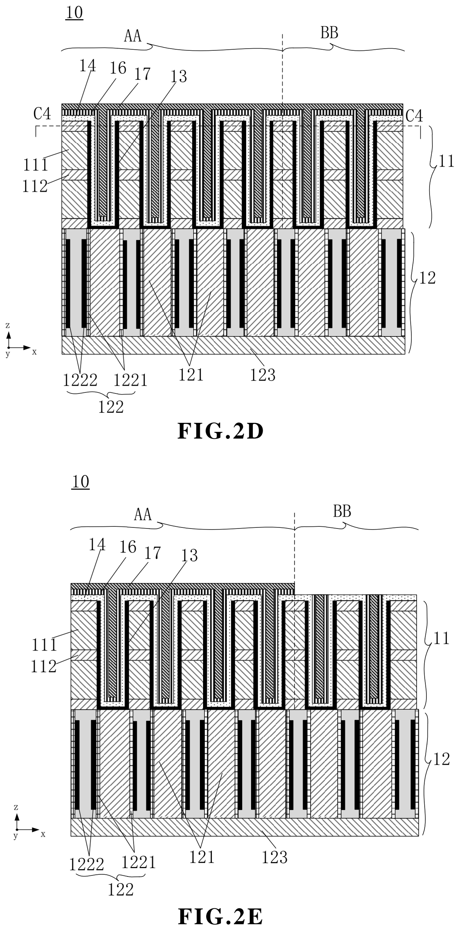

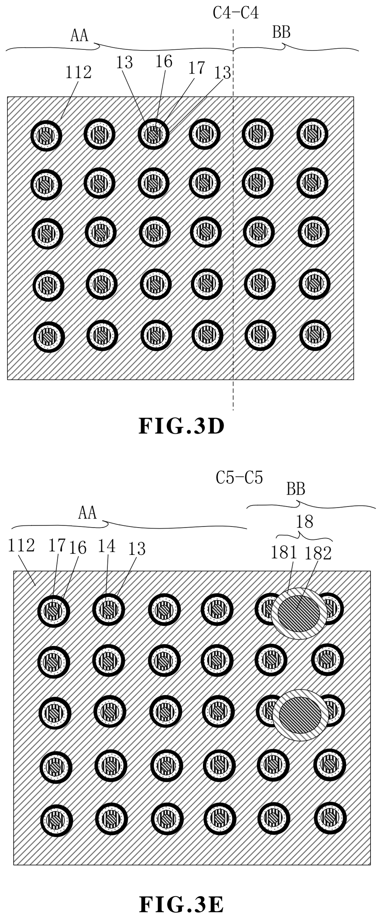

In some implementations, for example, if the semiconductor structure 10 comprises the cup capacitor structure, with continued reference to FIGs. 2C and 2D and 3D, FIG. 3D is a schematic cross-sectional structure view along a C4-C4 line in FIG. 2D. In an example, for the cup capacitor structure, the second electrode layer 16 is not only located on top of the first stack layer 11 (on the dielectric layer 14 on the top surface), but also located in the capacitor holes Q1 (on the dielectric layer 14 in the capacitor holes Q1).

In some implementations, for example, if the semiconductor structure 10 comprises the pillar capacitor structure, with continued reference to FIGs. 5C and 5D and 6D, FIG. 6D is a schematic cross-sectional structure view along a D4-D4 line in FIG. 5D. In an example, for the pillar capacitor structure, the second electrode layer 16 is not only located on top of the first stack layer 11 (on the dielectric layer 14 on the top surface) but also located in the spacing holes Q2 and the first empty slots Q3 (on the dielectric layer 14 in the spacing holes Q2 and the first empty slots Q3).

In some implementations, for example, if the semiconductor structure 10 comprises the cylindrical capacitor structure, with continued reference to FIGs. 7B and 7C and 8C, FIG. 8C is a schematic cross-sectional structure view along an E3-E3 line in FIG. 7C. In an example, for the cylindrical capacitor structure, the second electrode layer 16 is not only located on top of the first stack layer 11 (on the dielectric layer 14 on the top surface), but also located in the spacing holes Q2, the first empty slots Q3 and the second empty slots Q4 (on the dielectric layer 14 in the spacing holes Q2, the first empty slots Q3 and the second empty slots Q4).

Operation S105: removing the second electrode layer 16 on the first stack layer 11 in the second region BB.

The second electrode layer 16 on the top surface of the first stack layer 11 in the second region BB may be removed by a process such as back-etching, etc.

In some implementations, for example, if the semiconductor structure 10 comprises the cup capacitor structure, with continued reference to FIGs. 2C and 2D, after the formation of the second electrode layer 16, voids may still remain in the capacitor holes Q1 and need to be fully filled, that is, the fabrication method may further comprise: forming a semiconductor layer 17 on a side of the second electrode layer 16 in the first region AA and the second region BB facing away from the dielectric layer 14, wherein the semiconductor layer 17 fills the capacitor holes Q1.

A material of the semiconductor layer 17 includes a semiconductor material, such as at least one of polysilicon or silicide (such as, silicon germanium SiGe), etc. The semiconductor layer 17 is located on top of the first stack layer 11 (on the second electrode layer 16 at the top), and is in the capacitor holes Q1 (on the second electrode layer 16 in the capacitor holes Q1).

In an example, for the cup capacitor structure, after the formation of the semiconductor layer 17, the second electrode layer 16 in the first region AA and the second electrode layer 16 in the second region BB need to be partitioned. To this end, with continued reference to FIGs. 2D and 2E, the second electrode layer 16 on the first stack layer 11 in the second region BB may be removed directly. Meanwhile, since the semiconductor layer 17 is made from a conductive material, the semiconductor layer 17 on the first stack layer 11 in the second region BB needs to be further removed, thereby achieving partitioning of the second electrode layer 16 in the first region AA and in the second region BB, and achieving electrical insulation between them after power-on.

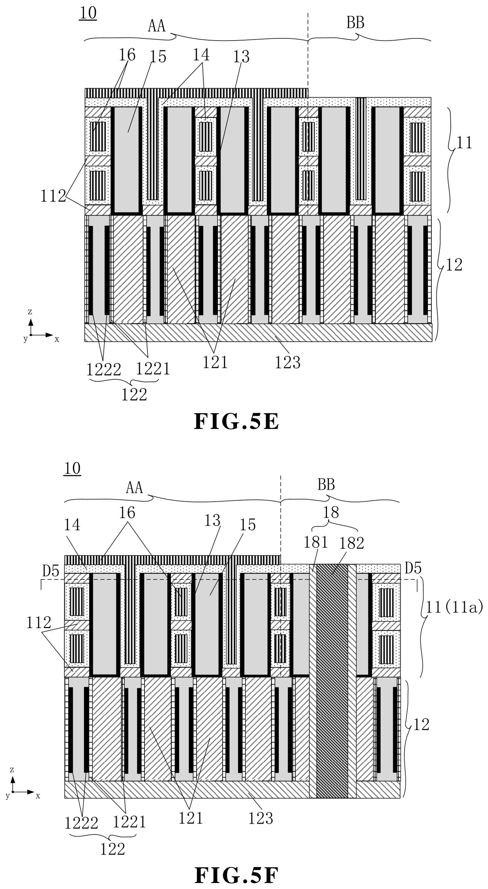

In some implementations, for example, if the semiconductor structure 10 comprises the pillar capacitor structure, with continued reference to FIGs. 5D and 5E, the partitioning of the second electrode layer 16 in the first region AA and in the second region BB may be achieved by directly removing the second electrode layer 16 on the first stack layer 11 in the second region BB.

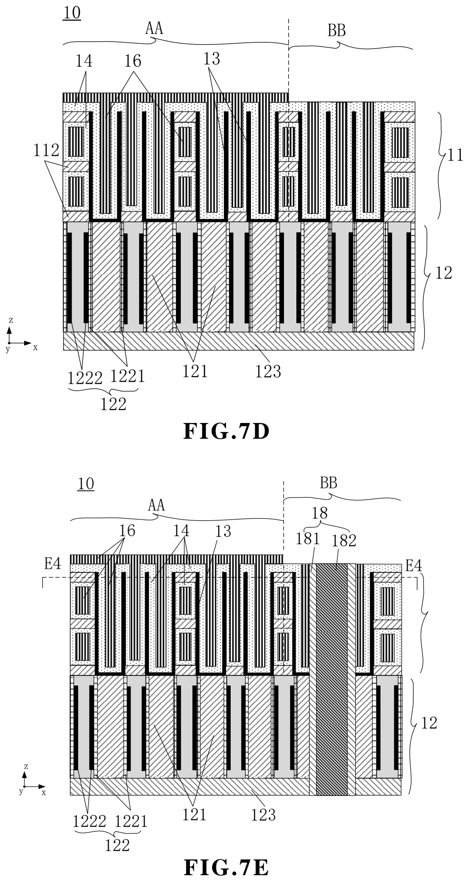

In some implementations, for example, if the semiconductor structure 10 comprises the cylindrical capacitor structure, with continued reference to FIGs. 7C and 7D, similar to the above pillar capacitor structure, in the cylindrical capacitor structure, the partitioning of the second electrode layer 16 in the first region AA and in the second region BB may be achieved by directly removing the second electrode layer 16 on the first stack layer 11 in the second region BB.

It is to be noted that, after the partitioning of the second electrode layer 16 in the first region AA and in the second region BB is achieved, the first electrode layer 13, the dielectric layer 14 and the second electrode layer 16 in the first region AA together serve as a capacitor structure that has a charge storage function. Meanwhile, since in the cylindrical capacitor structure, the second electrode layer 16 is also located in the second empty slots Q4 in addition to the spacing holes Q2 and the first empty slots Q3, compared with the pillar capacitor structure in which no second empty slot Q4 is formed, the cylindrical capacitor structure greatly increases effective area of the second electrode layer 16, thus improving charge storage capability of the capacitor structure.

Operation S106: forming a contact structure 18 penetrating through the first stack layer 11 in the second region BB along the stacking direction z.

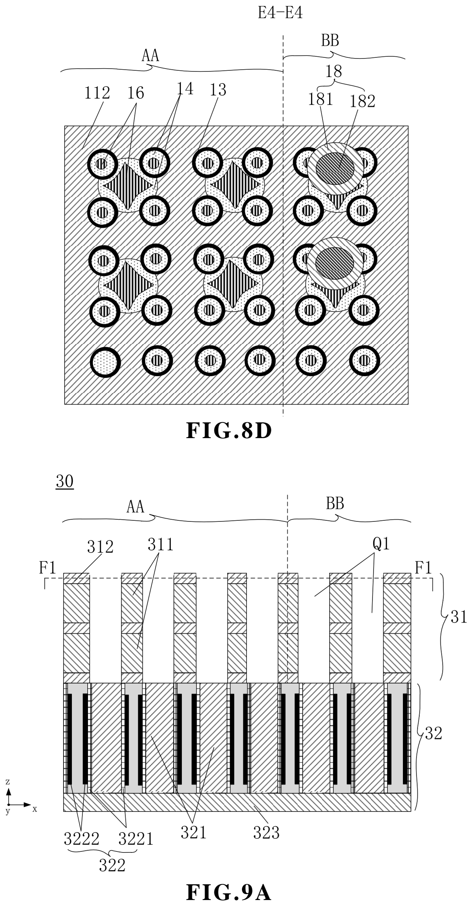

With continued reference to FIGs. 2F and 3E, 5F and 6E, and 7E and 8D, FIG. 3E is a schematic cross-sectional structure view along a C5-C5 line in FIG. 2F, FIG. 6E is a schematic cross-sectional structure view along a D5-D5 line in FIG. 5F, and FIG. 8D is a schematic cross-sectional structure view along an E4-E4 line in FIG. 7E. The specific number of the contact structure 18 and its formation position in the second region BB may be determined according to actual requirements, which is not limited here. The contact structure 18 may comprise an insulation layer 181, and a conductive layer 182 on a side of the insulation layer 181 facing away from the first stack layer 11. A material of the insulation layer 181 includes an insulation material such as silicon oxide, etc., and a material of the conductive layer 182 includes a metal material such as tungsten, etc. The contact structure 18 not only penetrates through the first stack layer 11, but also further penetrates through the second stack structure 12 along the stacking direction z and is connected with a peripheral circuit.

It is readily understood that, after the formation of the contact structure 18, the final first stack layer 11, for example, the first stack layer 11 with the sacrificial layers 111 being removed in the pillar capacitor structure, or the first stack layer 11 with the sacrificial layers 111 that are not needed to be removed in the cup capacitor structure, may serve as a first stack structure 11a.

Examples of the present application further provide a semiconductor structure 10. With continued reference to FIGs. 2F and 3E, 5F and 6E, and 7E and 8D, the semiconductor structure 10 may comprise a cup capacitor structure, a pillar capacitor structure or a cylindrical capacitor structure.

The semiconductor structure 10 comprises: a first stack structure 11a that comprises a first region AA and a second region BB; a first electrode layer 13 located in the first region AA and the second region BB, wherein the first electrode layer 13 penetrates through the first stack structure 11a along a stacking direction z, and the first electrode layer 13 in the first region AA and the first electrode layer 13 in the second region BB are disposed as being spaced apart; a dielectric layer 14 located in the first region AA and the second region BB; a second electrode layer 16 located in the first region AA and the second region BB, wherein the dielectric layer 14 is disposed between the first electrode layer 13 and the second electrode layer 16, and the second electrode layer 16 in the first region AA and the second electrode layer 16 in the second region BB are disposed as being spaced apart; and a contact structure 18 that penetrates through the first stack structure 11a in the second region BB along the stacking direction z.

The first region AA is a region corresponding to a memory array, the second region BB is another region, and the first region AA may adjoin the second region BB, for example, the second region BB is disposed around the first region AA. A material of the first electrode layer 13 includes a conductive material such as a metal, for example, tungsten, copper, etc. A material of the dielectric layer 14 includes a material with a high dielectric constant. A material of the second electrode layer 16 mainly includes a conductive material, which may be selected from any one or any combination of tungsten, cobalt, copper, aluminum, or polysilicon, and doped crystalline silicon.

The specific number of the contact structure 18 and its formation position in the second region BB may be determined according to actual requirements, which is not limited here. The contact structure 18 may comprise an insulation layer 181, and a conductive layer 182 on a side of the insulation layer 181 facing away from the first stack structure 11a. A material of the insulation layer 181 includes an insulation material such as silicon oxide, etc., and a material of the conductive layer 182 includes a metal material such as tungsten, etc.

In an example, the second electrode layer 16 in the first region AA and the second electrode layer 16 in the second region BB are disposed as being spaced apart, which mainly means that the second electrode layer 16 in the first region AA and the second electrode layer 16 in the second region BB are partitioned from each other, and do not have areas that are in direct contact. Moreover, interior portions of the first electrode layer 13 in the first region AA and interior portions of the first electrode layer 13 in the second region BB are both disposed as being spaced apart along a first direction x and a second direction y, , and the first direction x, the second direction y and the stacking direction z are perpendicular to one another, that is, the first electrode layer 13 in the first region AA and the first electrode layer 13 in the second region BB each comprises a plurality of partitioned portions that are not connected with each other. The first direction x and the second direction y may be an extending direction of a stack layer 11.

In some implementations, the dielectric layer 14 is located on a side of the first stack structure 11a and penetrates through part of the first stack structure 11a in the first region AA and the second region BB along the stacking direction z, and the second electrode layer 16 is located on the first stack structure 11a in the first region AA and covers a side of the dielectric layer 14 within the first stack structure 11a facing away from the first electrode layer 13. That is, the dielectric layer 14 is located on a top surface of the first stack structure 11a in the first region AA and the second region BB, and is within the first stack structure 11a, and the second electrode layer 16 is located on the top surface of the first stack structure 11a in the first region AA, and is within the first stack structure 11a. For different types of capacitor structures, the dielectric layer 14 and the second electrode layer 16 within the first stack structure 11a are disposed at different positions.

For example, in some implementations, with continued reference to FIGs. 2F and 3E, if the semiconductor structure 10 comprises the cup capacitor structure, the dielectric layer 14 within the first stack structure 11a covers a side of the first electrode layer 13 in the first region AA and the second region BB facing away from the first stack structure 11a.

In some implementations, with continued reference to FIGs. 2F and 3E, if the semiconductor structure 10 comprises the cup capacitor structure, the semiconductor structure 10 further comprises a semiconductor layer 17 that is located on the first stack structure 11a in the first region AA and covers a side of the second electrode layer 16 within the first stack structure 11a in the first region AA and the second region BB facing away from the dielectric layer 14.

The first electrode layer 13, the dielectric layer 14, the second electrode layer 16 and the semiconductor layer 17 in the first region AA may together serve as a capacitor structure. Moreover, since the first electrode layer 13 is disposed as being spaced apart, a plurality of capacitor structures disposed as being spaced apart and having a uniform size are formed in the first region AA. A material of the semiconductor layer 17 includes a semiconductor material, such as at least one of polysilicon or silicide (such as, silicon germanium SiGe), etc. The first electrode layer 13 within the first stack structure 11a is disposed around the dielectric layer 14 within the first stack structure 11a. The dielectric layer 14 within the first stack structure 11a is disposed around the second electrode layer 16 within the first stack structure 11a. The second electrode layer 16 within the first stack structure 11a is disposed around the semiconductor layer 17 within the first stack structure 11a.

For example, in some implementations, with continued reference to FIGs. 5F and 6E, and 7E and 8D, if the semiconductor structure 10 comprises the pillar capacitor structure or the cylindrical capacitor structure, the dielectric layer within the first stack structure 11a may be at least located between the two adjacent portions of the first electrode layer disposed as being spaced apart.

The first electrode layer 13, the dielectric layer 14 and the second electrode layer 16 in the first region AA may together serve as a capacitor structure. Moreover, since the first electrode layer 13 is disposed as being spaced apart, a plurality of capacitor structures disposed as being spaced apart and having a uniform size are formed in the first region AA.

In an example, with continued reference to FIGs. 5F and 6E, if the semiconductor structure 10 comprises the pillar capacitor structure, the semiconductor structure 10 further comprises a filling layer 15 within the first stack structure 11a in the first region AA and the second region BB, wherein interior portions of the filling layer 15 are disposed as being spaced apart, and the first electrode layer 13 is disposed around the filling layer 15. A material of the filling layer 15 may include carbon.

With continued reference to FIGs. 7E and 8D, if the semiconductor structure 10 comprises the cylindrical capacitor structure, the dielectric layer 14 within the first stack structure 11a further covers the side of the first electrode layer 13 facing away from the first stack structure 11a.

In some implementations, with continued reference to FIGs. 5F and 6E, and 7E and 8D, if the semiconductor structure 10 comprises the pillar capacitor structure or the cylindrical capacitor structure, the first stack structure 11a comprises a plurality of spacing layers 112 disposed in decks, and the dielectric layer 14 and the second electrode layer 16 are further located between two adjacent ones of the spacing layers 112 along the stacking direction z in the first region AA and the second region BB. A material of the spacing layers 112 may include silicon nitride.

In some implementations, with continued reference to FIGs. 2F and 3E, 5F and 6E, and 7E and 8D, if the semiconductor structure 10 comprises the cup capacitor structure, the pillar capacitor structure or the cylindrical capacitor structure, the semiconductor structure 10 may further comprise a second stack structure 12, wherein the second stack structure 12 is located on a side of the first stack structure 11a facing away from the second electrode layer 16, and comprises a plurality of channel structures 121 disposed as being spaced apart along the first direction x and the second direction y and gate structures 122 that extend along the second direction y and are connected with the plurality of channel structures 121, and the gate structure 122 is located between two adjacent ones of the channel structures 121,
wherein positions of the channel structures 121 at least correspond to a position of the first electrode layer 13 in the first region AA, and the contact structure 18 penetrates through the first stack structure 11a and the second stack structure 12 along the stacking direction z.

In some implementations, the positions of the channel structures 121 also correspond to a position of the first electrode layer 13 in the second region BB, and positions of the gate structures 122 at least correspond to the first region AA. That is, the gate structures 122 may be formed in positions corresponding to both the first region AA and the second region BB, or may be only formed in positions corresponding to the first region AA, which is not limited here.

In some implementations, the gate structure 122 may comprise a gate spacing layer 1221 and a gate layer 1222, wherein a material of the gate spacing layer 1221 may include an insulation material such as oxide, and a material of the gate layer 1222 may select any one or any combination of tungsten, cobalt, copper, aluminum, or polysilicon, and doped crystalline silicon. An insulation material may be further disposed between the gate structures 122 that are adjacent along the first direction x for isolation, to achieve electrical insulation between adjacent ones of the gate structures 122.

In some implementations, the semiconductor structure 10 may further comprise a bit line 123 that may be located on a side of the channel structure 121 facing away from the first stack structure 11a and connected with the channel structure 121.

It should be understood that, structures and fabrication processes of various component parts of the semiconductor structure 10 in the examples of the present application may refer to the above fabrication method examples of the semiconductor device 10, which is no longer repeated here.

As can be seen from above, according to the semiconductor structure 10 and the fabrication method thereof provided by the examples of the present application, the plurality of capacitor holes Q1 penetrating through the first stack layer 11 along the stacking direction z are formed, the first stack layer 11 comprises the first region AA and the second region BB, and the capacitor holes Q1 are located in the first region AA and the second region BB, such that a serious etch loading effect can be greatly avoided in the first region AA during the formation of the capacitor holes Q1, the size consistency of the capacitor holes Q1 in the first region AA is ensured as much as possible, and under-etching will not occur. Subsequently, the first electrode layer 13 is formed on the inner walls of the capacitor holes Q1; the dielectric layer 14 is formed in the first region AA and the second region BB; the second electrode layer 16 is formed on the side of the dielectric layer 14 facing away from the first stack layer 11; the second electrode layer 16 on the first stack layer 11 in the second region BB is removed; and the contact structure 18 penetrating through the first stack layer 11 in the second region BB along the stacking direction z is formed, such that the capacitor structures with a uniform size can be formed in the first region AA, thus improving reliability of the capacitor structures.

Examples of the present application further provide a fabrication method of another semiconductor structure 30. The fabrication method of the semiconductor structure 30 comprises the following operations S201-S206:
operation S201: forming a plurality of capacitor holes penetrating through a first stack layer along a stacking direction, wherein the first stack layer comprises a first region and a second region, and the capacitor holes are located in the first region and the second region;
operation S202: forming a first electrode layer on inner walls of the capacitor holes in the first region;
operation S203: removing part of the first stack layer in the first region and the second region;
operation S204: forming a dielectric layer and a second electrode layer in the first region, wherein the second electrode layer is located on a side of the dielectric layer facing away from the first electrode layer;
operation S205: forming a planar layer in the second region; and
operation S206: forming a contact structure penetrating through the planar layer along the stacking direction.

It should be understood that, the operations illustrated in the above fabrication method are not exclusive and other operations can also be performed before, after, or between any of the illustrated operations.

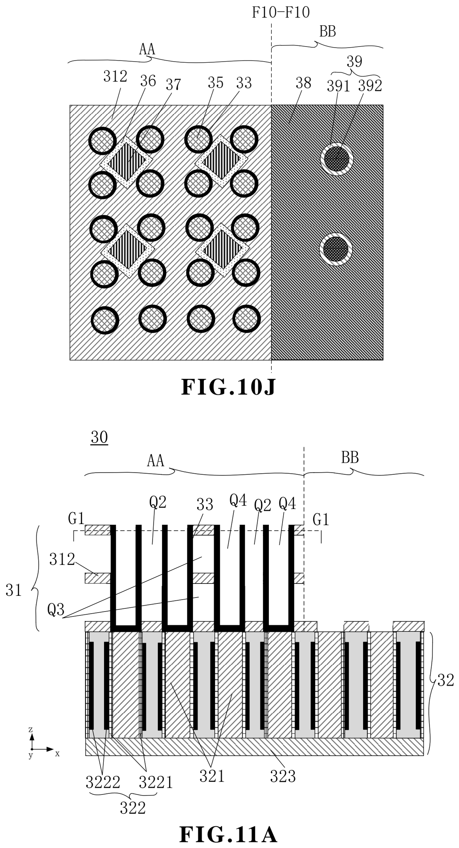

Referring to FIGs. 9A to 9J, and 11A to 11E, FIGs. 9A to 9J are schematic cross-sectional structure views of another semiconductor structure 30 in different process operations provided by examples of the present application, and FIGs. 11A to 11E are another schematic cross-sectional structure views of a semiconductor structure 30 in different process operations provided by examples of the present application. The semiconductor structure 30 may comprise a pillar capacitor structure or a cylindrical capacitor structure. The above operations S201-S206 will be further described below in conjunction with FIGs. 9A to 9J and 11A to 11E:

Operation S201: forming a plurality of capacitor holes Q1 penetrating through a first stack layer 31 along a stacking direction z, wherein the first stack layer 31 comprises a first region AA and a second region BB, and the capacitor holes Q1 are located in the first region AA and the second region BB.

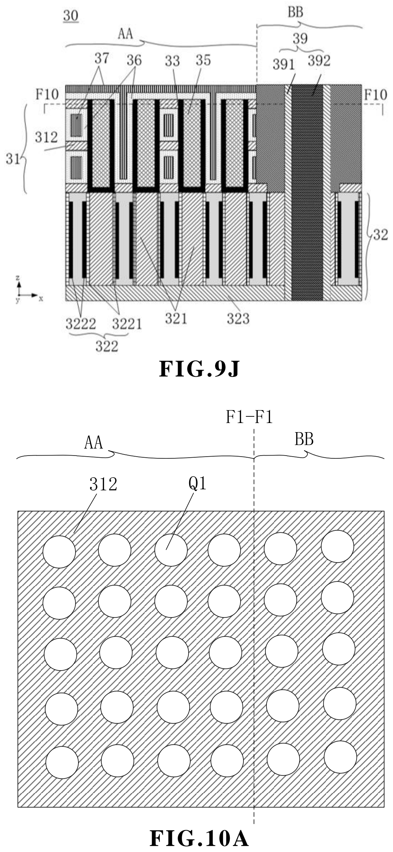

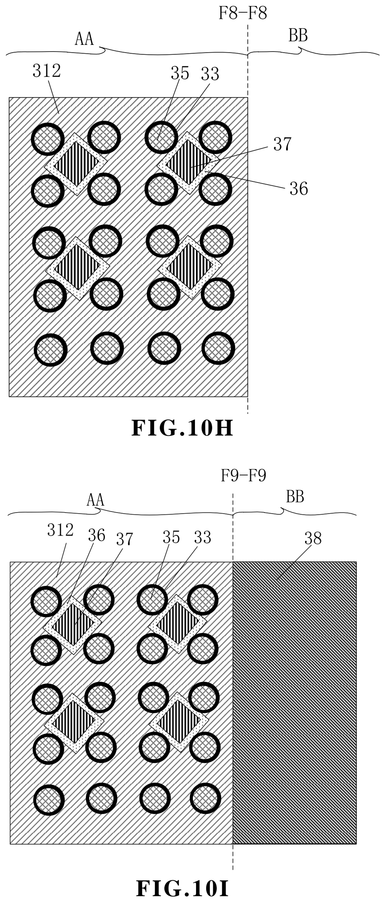

If the semiconductor structure 30 comprises the pillar capacitor structure or the cylindrical capacitor structure, referring to FIGs. 9A and 10A above, FIG. 10A is a schematic cross-sectional structure view along an F1-F1 line in FIG. 9A. The first region AA is a region corresponding to a memory array, the second region BB is another region, and the first region AA may adjoin the second region BB, for example, the second region BB is disposed around the first region AA. The capacitor holes Q1 may be distributed throughout the regions of the first stack layer 31, and interior portions of the capacitor holes Q1 are disposed as being spaced apart. In an example, these capacitor holes Q1 may be set to have the same size and the same spacing.

In an example, the first stack layer 31 may be formed using a thin film deposition process such as chemical vapor deposition (CVD), physical vapor deposition (PVD), atomic layer deposition (ALD) or any combination thereof. The first stack layer 31 may be formed by alternately stacking film layers of different insulation materials, for example, formed by alternately stacking film layers of silicon dioxide and silicon nitride.

The capacitor holes Q1 may be formed in both the first region AA and the second region BB of the first stack layer 31 through two patterning processes that are orthogonal or at a certain angle. At this point, patterns of the capacitor holes Q1 are distributed throughout a surface of the first stack layer 31 relatively uniformly, that is, density difference of etching patterns corresponding to the first region AA and the second region BB is small, so differences in etching depths and sizes of the capacitor holes Q1 finally formed in the first region AA and the second region BB are relatively small, which can avoid a serious etch loading effect as much as possible. Moreover, even if there is a certain etch loading effect which affects the etching depths and the hole sizes of the capacitor holes Q1 at an edge, the etch loading effect may generally only affect the outermost capacitor holes Q1 in the second region BB, and it is unlikely to affect the capacitor holes Q1 in the first region AA since the second region BB is typically disposed around the first region AA. Therefore, such a fabrication method of forming the capacitor holes Q1 in both the first region AA and the second region BB can greatly prevent the serious etch loading effect from occurring in the first region AA, so as to ensure the consistency of the etching depths and the sizes of the capacitor holes Q1 in the first region AA as much as possible, and avoid insufficient etching depths or too small sizes of part of the capacitor holes Q1.

In some implementations, before operation S201 above, the fabrication method may further comprise:
forming a second stack structure 32, wherein the second stack structure 32 comprises a plurality of channel structures 321 disposed as being spaced apart along a first direction x and a second direction y and gate structures 322 that extend along the second direction y and are connected with the plurality of channel structures 321, each of the gate structures 322 is located between two adjacent ones of the channel structures 321, and the first direction x, the second direction y and the stacking direction z are perpendicular to one another; and
forming the first stack layer 31 on the second stack structure 32.

Positions of the channel structures 321 at least correspond to positions of the capacitor holes Q1 in the first region AA. The first direction x and the second direction y may be an extending direction of the first stack layer 31. The first direction x, the second direction y and the stacking direction z of the first stack layer 31 are perpendicular to one another. The gate structure 322 may comprise a gate spacing layer 3221 and a gate layer 3222, wherein a material of the gate spacing layer 3221 may include an insulation material such as oxide, and a material of the gate layer 3222 may select any one or any combination of tungsten, cobalt, copper, aluminum, or polysilicon, and doped crystalline silicon.

In some implementations, the channel structures 321 are formed on a substrate that may include at least one of monocrystalline silicon (Si), monocrystalline germanium (Ge), a group III-V compound semiconductor material, a group II-VI compound semiconductor material or other semiconductor materials known in the art. In an example, first, the substrate is etched to form a plurality of active portions extending along the first direction x and disposed as being spaced apart along the second direction y on the substrate. Then, the gate structures 322 extending along the second direction y and at least connected with the active portions corresponding to the first region AA are formed, and the gate structures 322 penetrate through the active portions along the stacking direction z to obtain the channel structures 321.

In some implementations, an insulation material may be further filled between the gate structures 322 that are adjacent along the first direction x for isolation, to achieve electrical insulation between adjacent ones of the gate structures 322. After the filling of the insulation material, the substrate outside the channel structures 321 (i.e., the bottom substrate) may be removed, and a bit line 323 is fabricated and is connected with the channel structures 321.

In some implementations, the positions of the channel structures 321 may only correspond to the positions of the capacitor holes Q1 in the first region AA. Meanwhile, positions of the gate structures 322 only correspond to the first region AA, that is, the second stack structure 32 may comprise a core area corresponding to the first region AA and a non-core area corresponding to the second region BB, and the channel structures 321 and the gate structures 322 may be only located in the core area. In other implementations, the positions of the channel structures 321 may also correspond to positions of the capacitor holes Q1 in the second region BB. Meanwhile, the positions of the gate structures 322 may at least correspond to the first region AA, that is, the channel structures 321 may be located in the core area and the non-core area (for example, with continued reference to FIG. 9A), and the gate structures 322 may be located in the core area and the non-core area, or be only located in the core area, which is not limited here.

Operation S202: forming a first electrode layer 33 on inner walls of the capacitor holes Q1 in the first region AA.

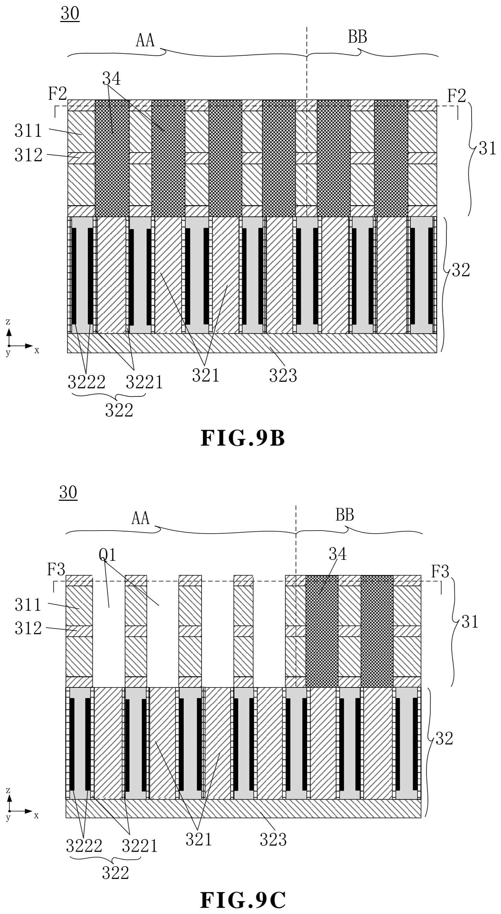

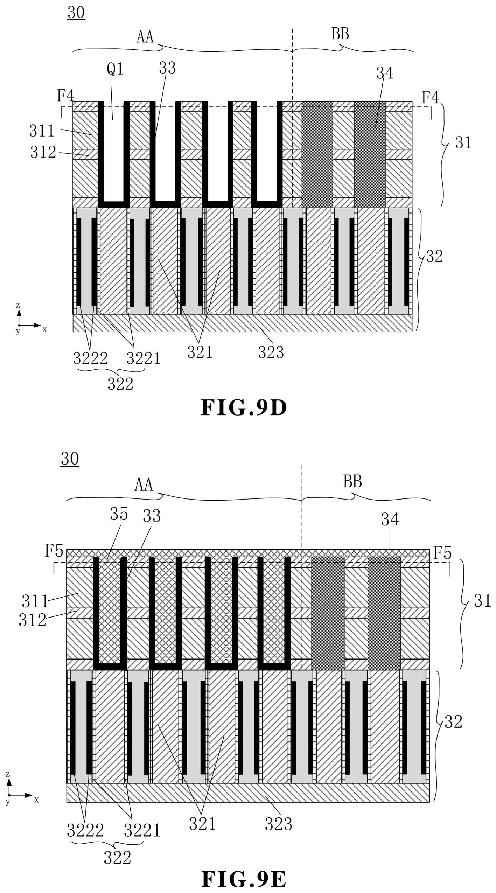

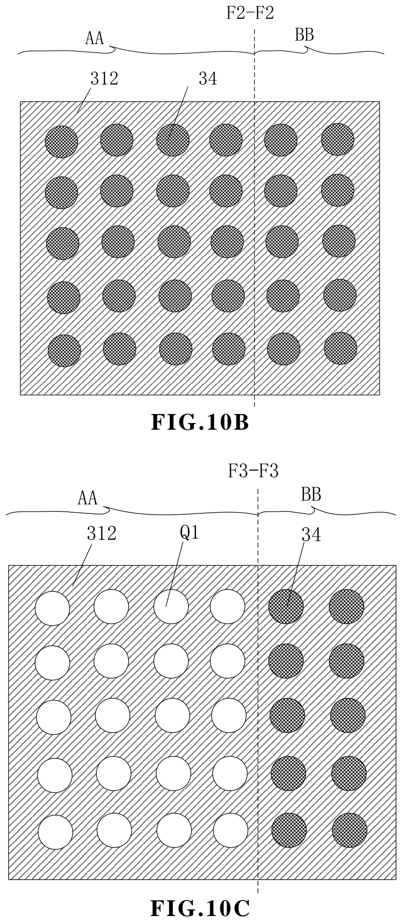

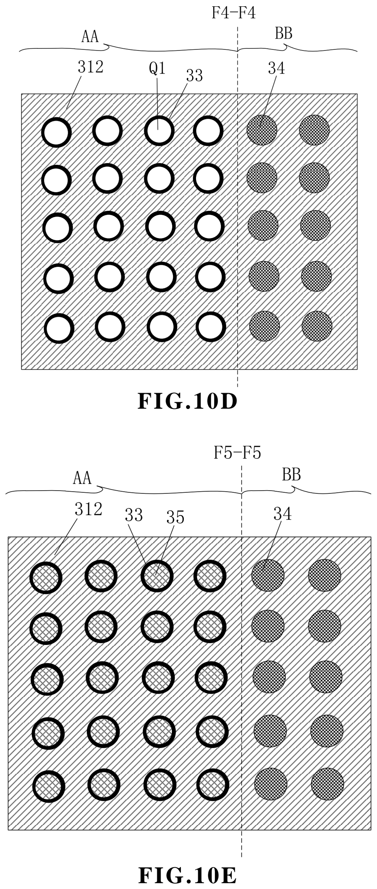

In some implementations, if the semiconductor structure 30 comprises the pillar capacitor structure or the cylindrical capacitor structure, with continued reference to FIGs. 9A to 9D, and 10B to 10D, FIG. 10B is a schematic cross-sectional structure view along an F2-F2 line in FIG. 9B, FIG. 10C is a schematic cross-sectional structure view along an F3-F3 line in FIG. 9C, and FIG. 10D is a schematic cross-sectional structure view along an F4-F4 line in FIG. 9D. Before the above operation S202, the fabrication method further comprises:
forming sacrificial structures 34 in the capacitor holes Q1 in the first region AA and the second region BB; and
removing the sacrificial structures 34 in the first region AA, and exposing the capacitor holes Q1 in the first region AA;
at this point, the above operation S202 comprises: forming the first electrode layer 33 on the inner walls of the capacitor holes Q1.

A material of the first electrode layer 33 includes a conductive material such as a metal or a metal compound, for example, tungsten, copper, titanium nitride (TiN), etc. A material of the sacrificial structures 34 includes carbon. The sacrificial structures 34 are formed, and the sacrificial structures 34 in the first region AA are removed to expose the capacitor holes Q1 in the first region AA, with the sacrificial structures 34 in the second region BB being remained, such that the capacitor structure may be only formed in the first region AA subsequently.

In an example, a layer of conductive material may be formed on a side of the first stack layer 31, and the conductive material may cover the inner walls of the exposed capacitor holes Q1 in the first region AA. Thereafter, the conductive material outside the inner walls of the capacitor holes Q1 is removed, so as to obtain the first electrode layer 33 in the first region AA.

It is to be noted that, since the capacitor holes Q1 are disposed as being spaced apart in the first region AA and the second region BB, the first electrode layer 33 in the first region AA is also disposed as being spaced apart, that is, the first electrode layer 33 in the first region AA comprises a plurality of partitioned portions that are not connected with each other.

Operation S203: removing part of the first stack layer 31 in the first region AA and the second region BB.

If the semiconductor structure 30 comprises the pillar capacitor structure or the cylindrical capacitor structure, in order to prevent the first stack layer 31 from collapsing when part of the first stack layer 31 is removed, the capacitor holes Q1 in the first region AA needs to be fully filled first.

In some implementations, with continued reference to FIGs. 9D and 9E, and 10E, FIG. 10E is a schematic cross-sectional structure view along an F5-F5 line in FIG. 9E. Before the above operation S203, the fabrication method may further comprise:
forming a filling layer 35 on a side of the first stack layer 31 in the first region AA and the second region BB, wherein the filling layer 35 covers a side of the first electrode layer 33 in the first region AA facing away from the inner walls of the capacitor holes Q1 and fills the capacitor holes Q1 in the first region AA.

A material of the filling layer 35 may include a material with good hardness, such as polysilicon. The filling layer 35 is located on a top surface of the first stack layer 31 in the first region AA and the second region BB, and is in the capacitor holes Q1 of the first region AA.

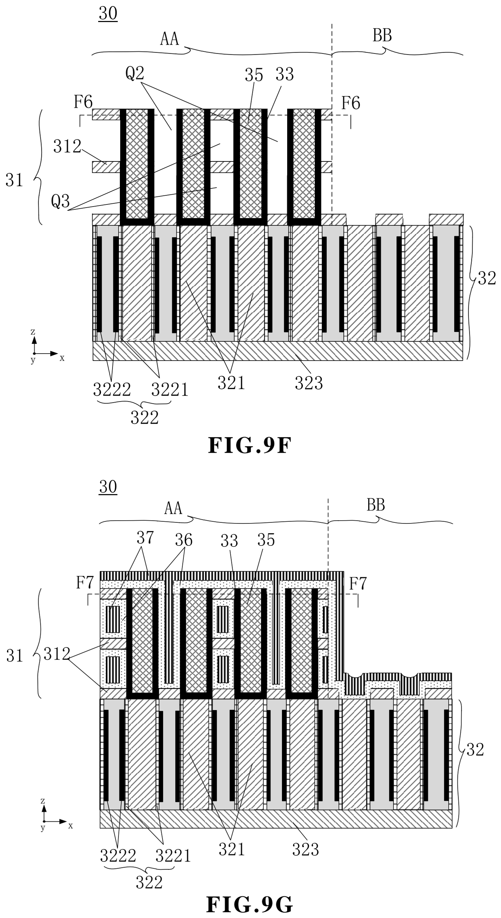

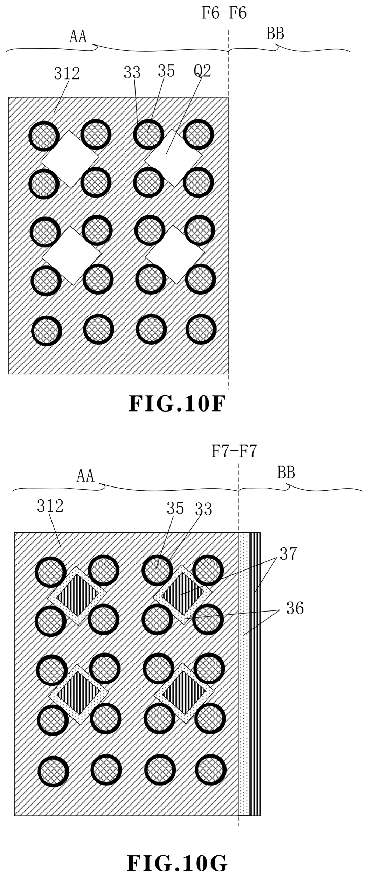

In an example, after the capacitor holes Q1 in the first region AA are fully filled, if the semiconductor structure 30 comprises the pillar capacitor structure, with continued reference to FIGs. 9E and 9F, and 10F, FIG. 10F is a schematic cross-sectional structure view along an F6-F6 line in FIG. 9F.

The first stack layer 31 may comprise sacrificial layers 311 and spacing layers 312 disposed alternately. The above operation S203 may comprise:
forming a plurality of spacing holes Q2 penetrating through part of the first stack layer 31 in the first region AA along the stacking direction z, and removing the sacrificial layers 311 to form first empty slots Q3; and
removing the sacrificial structures 34 in the second region BB.

A material of the sacrificial layers 311 may include silicon dioxide, and a material of the spacing layers 312 may include silicon nitride. The spacing holes Q2 further penetrate through the filling layer 35 along the stacking direction z, extend into the first stack layer 31, and are only located in the first region AA.

In an example, the spacing holes Q2 are formed by multiple times of etching, for example, a hole pattern corresponding to the spacing holes Q2 is formed on the filling layer 35 on top of the first stack layer 31 in the first region AA through a mask, and the filling layer on top of the first stack layer 31 in the second region BB is removed. Thereafter, the top spacing layer 312 continues to be etched down via the pattern of the filling layer 35, and part of the adjacent sacrificial layer 311 below is exposed. Then, the sacrificial layer 311 is removed via wet etching or dry etching through the exposed positions, and the adjacent spacing layer 312 below is exposed. Next, the exposed spacing layer 312 continues to be etched down to further expose the adjacent sacrificial layer 311 below. Next, the sacrificial layer 311 is removed through exposed positions of the sacrificial layer 311. All the sacrificial layers 311 within the first stack layer 31 are removed by multiple times of etching, with only the bottom spacing layer 312 being remained, thereby obtaining the spacing holes Q2 penetrating through part of the first stack layer 31 along the stacking direction z.

It is to be noted that, only one cross-sectional shape (square as shown in the figures) and arrangement of the spacing holes Q2 is illustrated in the figures. In other implementations, the spacing holes Q2 may comprise other cross-sectional shapes (for example, trapezoid, circle) and arrangements, which is not limited here. In other implementations, in addition to the above-mentioned multiple times of etching, the spacing holes Q2 may be formed by other means, which is not limited here.

Meanwhile, during the formation of the spacing holes Q2, the sacrificial layers 311 may be removed together to obtain the first empty slots Q3. While in this process, the sacrificial structures 34 in the second region BB and the filling layer in the first region AA can play a better role of supporting. Thereafter, the sacrificial structures 34 (i.e., the remaining sacrificial structures 34) in the second region BB are also removed, such that only the bottom spacing layer 312 is remained in the second region BB.

In some implementations, if the semiconductor structure 30 comprises the cylindrical capacitor structure, referring to FIGs. 11A to 11E, FIGs. 11A to 11E are another schematic cross-sectional structure views of the semiconductor structure 30 in different process operations provided by examples of the present application. With continued reference to FIGs. 9E and 11A, and 12A, FIG. 12A is a schematic cross-sectional structure view along a G1-G1 line in FIG. 11A, and the above operation S203 may further comprise:
removing the filling layer 35 within the capacitor holes Q1 in the first region AA to form second empty slots Q4.

Similar to the above-mentioned pillar capacitor structure, the cylindrical capacitor structure also requires forming the above-mentioned spacing holes Q2 and the first empty slots Q3, only except that the cylindrical capacitor structure further requires forming the second empty slots Q4.

Operation S204: forming a dielectric layer 36 and a second electrode layer 37 in the first region AA, wherein the second electrode layer 37 is located on a side of the dielectric layer 36 facing away from the first electrode layer 33.

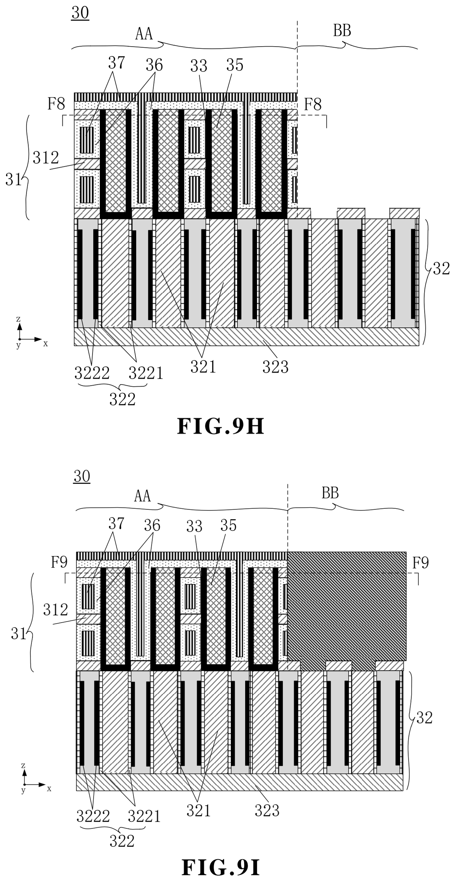

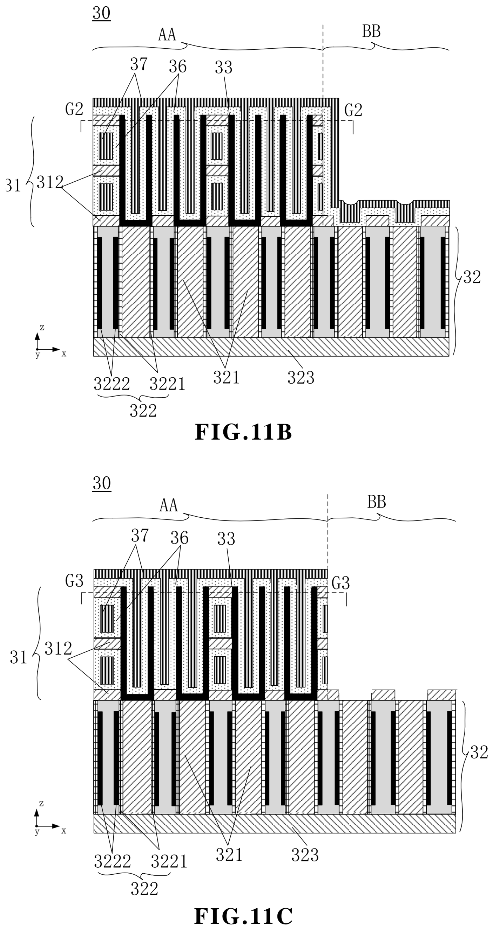

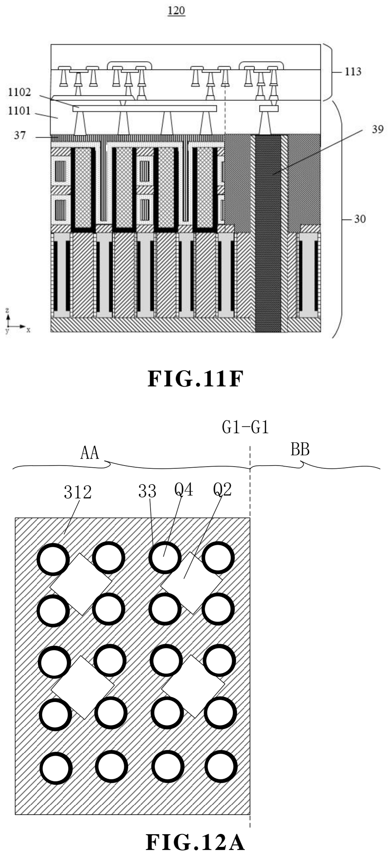

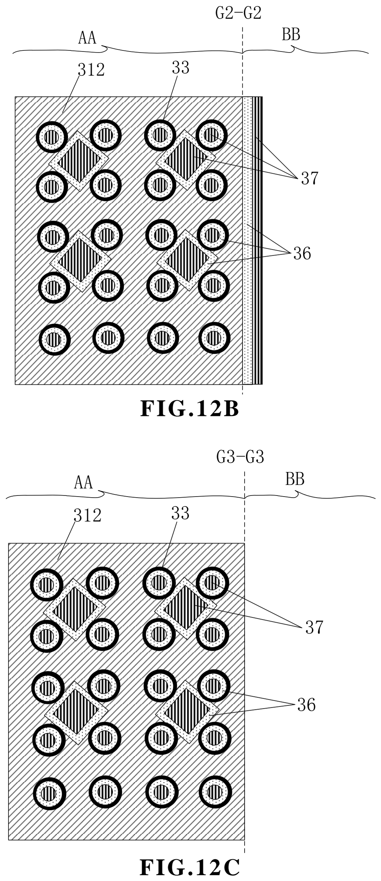

If the semiconductor structure 30 comprises the pillar capacitor structure, with continued reference to FIGs. 9F to 9H, and 10G and 10H, FIG. 10G is a schematic cross-sectional structure view along an F7-F7 line in FIG. 9G, and FIG. 10H is a schematic cross-sectional structure view along an F8-F8 line in FIG. 9H. The dielectric layer 36 and the second electrode layer 37 are not only located on top of the first stack layer 31, but also fill the spacing holes Q2 and the first empty slots Q3. If the semiconductor structure 30 comprises the cylindrical capacitor structure, with continued reference to FIGs. 11A to 11C, and 12B and 12C, FIG. 12B is a schematic cross-sectional structure view along a G2-G2 line in FIG. 11B, and FIG. 12C is a schematic cross-sectional structure view along a G3-G3 line in FIG. 11C. The dielectric layer 36 and the second electrode layer 37 are not only located on top of the first stack layer 31, but also fill the spacing holes Q2, the first empty slots Q3, and the second empty slots Q4.

A material of the dielectric layer 36 includes a material with a high dielectric constant, and the dielectric layer 36 may be formed using a thin film deposition process. A material of the second electrode layer 37 mainly includes a conductive material, which may be selected from any one or any combination of tungsten, cobalt, copper, aluminum, titanium nitride, silicon germanium, or polysilicon, and doped crystalline silicon.

In some implementations, the above operation S204 may comprise:
forming the dielectric layer 36 on a side of the first stack layer 31 in the first region AA and the second region BB;
forming the second electrode layer on a side of the dielectric layer 36 facing away from the first stack layer 31; and
removing the dielectric layer 36 and the second electrode layer 37 in the second region BB.

The dielectric layer 36 and the second electrode layer 37 may be formed using a thin film deposition process. The dielectric layer 36 and the second electrode layer 37 in the second region BB are removed by dry etching, with only the dielectric layer 36 and the second electrode layer 37 in the first region AA being remained. At this point, only part of the bottom spacing layer 312 is remained in the second region BB.

Operation S205: forming a planar layer 38 in the second region BB.

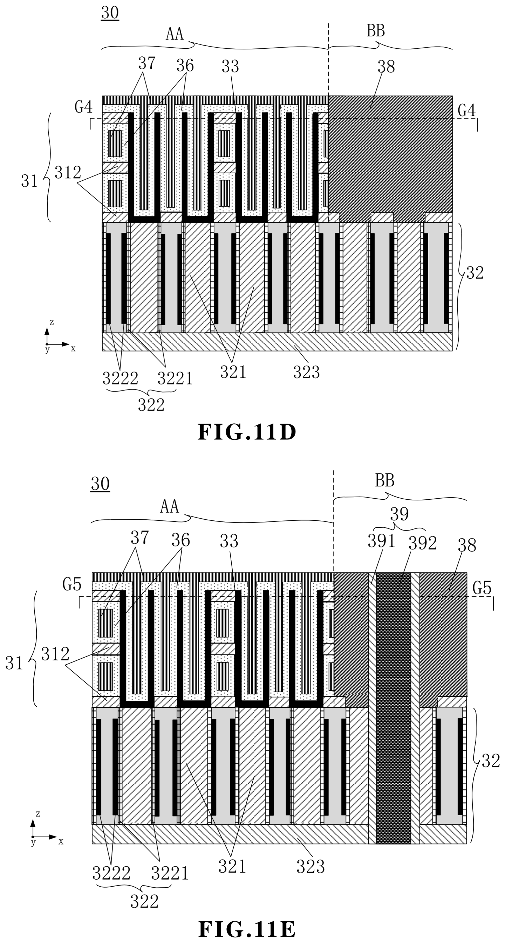

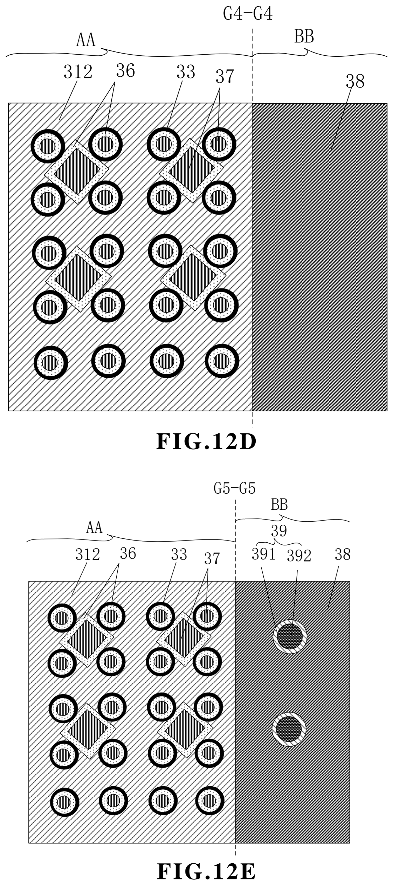

If the semiconductor structure 30 comprises the pillar capacitor structure or the cylindrical capacitor structure, with continued reference to respective FIGs. 9I and 10I, and 11D and 12D, FIG. 10I is a schematic cross-sectional structure view along an F9-F9 line in FIG. 9I, and FIG. 12D is a schematic cross-sectional structure view along a G4-G4 line in FIG. 11D. A material of the planar layer 38 may include an oxide, such as silicon dioxide. The planar layer 38 may be processed through CMP (chemical mechanical polishing), to make a top surface of the planar layer 38 be approximately flush with a top surface of the second electrode layer 37 in the first region AA.

Operation S206: forming a contact structure 39 penetrating through the planar layer 38 along the stacking direction z.

If the semiconductor structure 30 comprises the pillar capacitor structure or the cylindrical capacitor structure, with continued reference to respective FIGs. 9J and 10J, and 11E and 12E, FIG. 10J is a schematic cross-sectional structure view along an F10-F10 line in FIG. 9J, and FIG. 12E is a schematic cross-sectional structure view along a G5-G5 line in FIG. 11E. The contact structure 39 may be located in any position in the second region BB, and the specific number of the contact structure 39 and its formation position in the second region BB may be determined according to actual requirements, which is not limited here. The contact structure 39 may comprise an insulation layer 391 and a conductive layer 392 on a side of the insulation layer 391 facing away from the first stack layer 31. A material of the insulation layer 391 includes an insulation material such as silicon oxide, etc., and a material of the conductive layer 392 includes a metal material such as tungsten, etc. The contact structure 39 not only penetrates through the planar layer 38, but also further penetrates through the second stack structure 32 along the stacking direction z and is connected with a peripheral circuit.

Examples of the present application further provide a semiconductor structure 30, with continued reference to FIGs. 9J, 10J, 11E, 12E and 11F above.

The semiconductor structure 30 comprises a second stack structure 32, a first stack layer 31 and a capacitor structure, wherein the capacitor structure is located within the first stack layer 31, and the first stack layer 31 is located on the second stack structure 32 and comprises a first region AA and a second region BB. The second stack structure 32 comprises a plurality of channel structures 321 disposed as being spaced apart along a first direction x and a second direction y, and gate structures 322 that extend along the second direction y and are connected with the plurality of channel structures 321. Each of the gate structures 322 is located between two adjacent ones of the channel structures 321. The first region AA of the first stack layer 31 has capacitor holes Q1 disposed as being spaced apart, and positions of the channel structures 321 at least correspond to positions of the capacitor holes Q1 in the first region AA. The gate structure 322 may comprise a gate spacing layer 3221 and a gate layer 3222. The gate spacing layer 3221 is located between the gate layer 3222 and the channel structure 321. Adjacent ones of the gate structures 322 are isolated and electrically insulated through an insulation material. The second stack structure 32 further comprises a bit line 323 that is located on a side of the second stack structure 32 away from the first stack layer 31 and is connected with the channel structures 321.

The first stack layer 31 comprises spacing layers 312 disposed as being spaced apart in a stacking direction z. The spacing layers 312 are each located at an end of the second stack structure 32 away from the bit line 323. There are first empty slots Q3 between two adjacent ones of the spacing layers 312, and the capacitor holes Q1 penetrate through the spacing layers 312. A material of the spacing layers 312 may include silicon nitride.

Referring to FIG. 9J, in some examples, the capacitor structure further comprises a first electrode layer 33, a dielectric layer 36 and a second electrode layer 37, wherein the first electrode layer 33 is located on inner walls of the capacitor holes Q1 in the first region AA, that is, the first electrode layer 33 is connected with the spacing layers 312 and the channel structures 321. Due to the presence of the capacitor holes Q1, the first electrode layer 33 and the spacing layers 312 each comprises a plurality of partitioned portions that are not connected with each other. The dielectric layer 36 is located on a side of the first stack layer 31 in the first region AA and covers a side of the first electrode layer 33 facing away from the second stack structure 32, and the second electrode layer 37 is located on a side of the dielectric layer 36 in the first region AA facing away from the first electrode layer 33. The first stack layer 31 further comprises a filling layer 35, and the filling layer 35 is located on a side of the first electrode layer 33 facing away from the spacing layer 312 and the second stack structure 32 and is filled within the capacitor holes Q1, that is, the first electrode layer 33 is disposed around the filling layer 35. The dielectric layer 36 further covers the filling layer 35. The dielectric layer 36 and the second electrode layer 37 are also filled within the first empty slots Q3, and the dielectric layer 36 filled within the first empty slots Q3 is connected with the spacing layers 312 and the first electrode layer 33 and surrounds the second electrode layer 37 filled within the first empty slots Q3. Spacing holes Q2 penetrating through at least part of the spacing layers 312 along the stacking direction z are further disposed in the first stack layer 31. The spacing hole Q2 takes two adjacent portions of the first electrode layer 33 extending along the stacking direction z as inner walls. The dielectric layer 36 and the second electrode layer 37 are also filled within the spacing holes Q2. That is, the dielectric layer 36 within the spacing holes Q2 is connected with the spacing layers 312 on the second stack structure 32, and the dielectric layer 36 within the spacing holes Q2 surrounds the second electrode layer 37 within the spacing holes Q2.

Since the first electrode layer 33 is disposed as being spaced apart, a plurality of capacitor structures disposed as being spaced apart and having a uniform size are formed in the first region AA.

Referring to FIG. 11E, in some examples, the filling layer 35 in the capacitor holes Q1 may be also replaced by the dielectric layer 36 and the second electrode layer 37, that is, between two adjacent partitions of the spacing layers 312, there are a plurality of portions of the first electrode layer 33 that are opposite to positions of the channel structures 321 and connected with the channel structures 321, and two adjacent portions of the first electrode layer 33 are spaced apart by the dielectric layer 36. Part of the second electrode layer 37 is filled within a slit formed by the dielectric layer 36, and is disposed oppositely to the first electrode layer 33 in the stacking direction z.

The semiconductor structure 30 further comprises a planar layer 38 in the second region BB. The planar layer 38 is disposed adjacent to the first stack layer 31 in the first region AA and is located on a side of the second stack structure 32 away from the bit line 323. A part of the spacing layers 312 on the second stack structure 32 is located within the second region BB, and the planar layer 38 covers the spacing layers 312 within the second region BB and the second stack structure 32.

The semiconductor structure 30 further comprises a contact structure 39 penetrating through the planar layer 38 along the stacking direction z. The contact structure 39 may comprise an insulation layer 391, and a conductive layer 392 on a side of the insulation layer 391 facing away from the first stack layer 31. A material of the insulation layer 391 includes an insulation material such as silicon oxide, etc., and a material of the conductive layer 392 includes a metal material such as tungsten, etc. The contact structure 39 not only penetrates through the planar layer 38, but also further penetrates through the second stack structure 32 along the stacking direction z and is connected with a peripheral circuit.

Referring to FIG. 11F, the semiconductor structure 30 further comprises an interconnection dielectric layer 1101 and an interconnection circuit layer 1102 that is within the interconnection dielectric layer 1101 and connected with the second electrode layer 37.

As can be seen from above, according to the fabrication method of the semiconductor structure 30 provided by the examples of the present application, the plurality of capacitor holes Q1 penetrating through the first stack layer 31 along the stacking direction z are formed, the first stack layer 31 comprises the first region AA and the second region BB, and the capacitor holes Q1 are located in the first region AA and the second region BB, such that a serious etch loading effect can be greatly avoided in the first region AA during the formation of the capacitor holes Q1, the size consistency of the capacitor holes Q1 in the first region AA is ensured as much as possible, and under-etching will not occur. Subsequently, the first electrode layer 33 is formed on the inner walls of the capacitor holes Q1; part of the first stack layer 31 in the first region AA and the second region BB is removed; the dielectric layer 36 and the second electrode layer 37 are formed in the first region AA; the second electrode layer 37 is formed on the side of the dielectric layer 36 facing away from the first electrode layer 33; the planar layer 38 is formed in the second region BB; and the contact structure 39 penetrating through the planar layer 38 along the stacking direction z is formed, such that the capacitor structures with a uniform size can be formed in the first region AA, thus improving reliability of the capacitor structures.

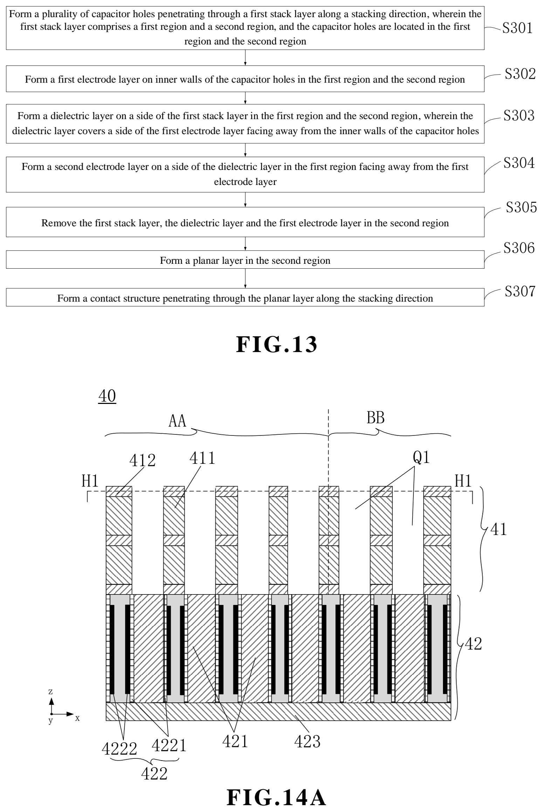

Examples of the present application further provide a flow diagram of a fabrication method of another semiconductor structure. Referring to FIG. 13, the fabrication method of the semiconductor structure may comprise the following operations S301-S307:
operation S301: forming a plurality of capacitor holes penetrating through a first stack layer along a stacking direction, wherein the first stack layer comprises a first region and a second region, and the capacitor holes are located in the first region and the second region;
operation S302: forming a first electrode layer on inner walls of the capacitor holes in the first region and the second region;
operation S303: forming a dielectric layer on a side of the first stack layer in the first region and the second region, wherein the dielectric layer covers a side of the first electrode layer facing away from the inner walls of the capacitor holes;
operation S304: forming a second electrode layer on a side of the dielectric layer in the first region facing away from the first electrode layer;
operation S305: removing the first stack layer, the dielectric layer and the first electrode layer in the second region;
operation S306: forming a planar layer in the second region; and
operation S307: forming a contact structure penetrating through the planar layer along the stacking direction.

It should be understood that, the operations illustrated in the above fabrication method are not exclusive, and other operations can also be performed before, after, or between any of the illustrated operations.

Referring to FIGs. 14A to 14H, FIGs. 14A to 14H are schematic cross-sectional structure views of another semiconductor structure 40 in different process operations provided by examples of the present application. The semiconductor structure 40 may comprise a cup capacitor structure. The above operations S301-S307 will be further described below in conjunction with FIGs. 14A to 14H:
Operation S301: forming a plurality of capacitor holes Q1 penetrating through a first stack layer 41 along a stacking direction z, wherein the first stack layer 41 comprises a first region AA and a second region BB, and the capacitor holes Q1 are located in the first region AA and the second region BB.

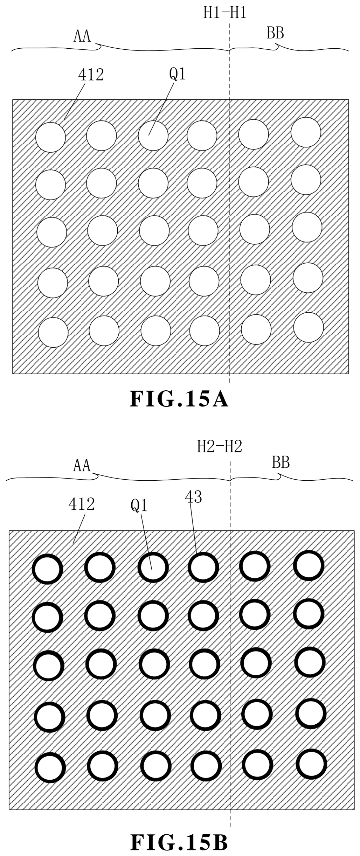

With continued reference to FIGs. 14A and 15A, FIG. 15A is a schematic cross-sectional structure view along an H1-H1 line in FIG. 14A. The first region AA is a region corresponding to a memory array, the second region BB is another region, and the first region AA may adjoin the second region BB, for example, the second region BB is disposed around the first region AA. The capacitor holes Q1 may be distributed throughout the regions of the first stack layer 41, and interior portions of the capacitor holes Q1 are disposed as being spaced apart. In an example, these capacitor holes Q1 may be set to have the same size and the same spacing.

In an example, the first stack layer 41 may be formed using a thin film deposition process such as chemical vapor deposition (CVD), physical vapor deposition (PVD), atomic layer deposition (ALD) or any combination thereof. The first stack layer 41 may comprise sacrificial layers 411 and spacing layers 412 that are disposed alternately. A material of the sacrificial layers 411 may include silicon dioxide, and a material of the spacing layers 412 may include silicon nitride.

The capacitor holes Q1 may be formed in both the first region AA and the second region BB of the first stack layer 41 through two patterning processes that are orthogonal or at a certain angle. At this point, patterns of the capacitor holes Q1 are distributed throughout a surface of the first stack layer 41 relatively uniformly, that is, density difference of etching patterns corresponding to the first region AA and the second region BB is small, so differences in etching depths and sizes of the capacitor holes Q1 finally formed in the first region AA and the second region BB are relatively small, which can avoid a serious etch loading effect as much as possible. Moreover, even if there is a certain etch loading effect which affects the etching depths and the hole sizes of the capacitor holes Q1 at an edge, the etch loading effect may generally only affect the outermost capacitor holes Q1 in the second region BB, and it is unlikely to affect the capacitor holes Q1 in the first region AA since the second region BB is typically disposed around the first region AA. Therefore, such a fabrication method of forming the capacitor holes Q1 in both the first region AA and the second region BB can greatly prevent the serious etch loading effect from occurring in the first region AA, so as to ensure the consistency of the etching depths and the sizes of the capacitor holes Q1 in the first region AA as much as possible, and avoid insufficient etching depths or too small sizes of part of the capacitor holes Q1.

In some implementations, before the above operation S301, the fabrication method may further comprise:
forming a second stack structure 42, wherein the second stack structure 42 comprises a plurality of channel structures 421 disposed as being spaced apart along a first direction x and a second direction y and gate structures 422 that extend along the second direction y and are connected with the plurality of channel structures 421, each of the gate structures 422 is located between two adjacent ones of the channel structures 421, and the first direction x, the second direction y and the stacking direction z are perpendicular to one another; and
forming the first stack layer 41 on the second stack structure 42.

Positions of the channel structures 421 at least correspond to positions of the capacitor holes Q1 in the first region AA. The first direction x and the second direction y may be an extending direction of the first stack layer 41. The first direction x, the second direction y and the stacking direction z of the first stack layer 41 are perpendicular to one another. The gate structure 422 may comprise a gate spacing layer 4221 and a gate layer 4222, wherein a material of the gate spacing layer 4221 may include an insulation material such as oxide, and a material of the gate layer 4222 may select any one or any combination of tungsten, cobalt, copper, aluminum, or polysilicon, and doped crystalline silicon.

In some implementations, the channel structures 421 are formed on a substrate that may include at least one of monocrystalline silicon (Si), monocrystalline germanium (Ge), a group III-V compound semiconductor material, a group II-VI compound semiconductor material or other semiconductor materials known in the art. In an example, first, the substrate is etched to form a plurality of active portions extending along the first direction x and disposed as being spaced apart along the second direction y on the substrate. Then, the gate structures 422 extending along the second direction y and at least connected with the active portions corresponding to the first region AA are formed, and the gate structures 422 penetrate through the active portions along the stacking direction z to obtain the channel structures 421.

In some implementations, an insulation material may be further filled between the gate structures 422 that are adjacent along the first direction x for isolation, to achieve electrical insulation between adjacent ones of the gate structures 422. After the filling of the insulation material, the substrate outside the channel structures 421 (i.e., the bottom substrate) may be removed, and a bit line 423 is fabricated and is connected with the channel structures 421.

In some implementations, the positions of the channel structures 421 may only correspond to the positions of the capacitor holes Q1 in the first region AA. Meanwhile, positions of the gate structures 422 only correspond to the first region AA, that is, the second stack structure 42 may comprise a core area corresponding to the first region AA and a non-core area corresponding to the second region BB, and the channel structures 421 and the gate structures 422 may be only located in the core area. In other implementations, the positions of the channel structures 421 may also correspond to positions of the capacitor holes Q1 in the second region BB. Meanwhile, the positions of the gate structures 422 may at least correspond to the first region AA, that is, the channel structures 421 may be located in the core area and the non-core area (for example, with continued reference to FIG. 14A), and the gate structures 422 may be located in the core area and the non-core area, or be only located in the core area, which is not limited here.

Operation S302: forming a first electrode layer 43 on inner walls of the capacitor holes Q1 in the first region AA and the second region BB.

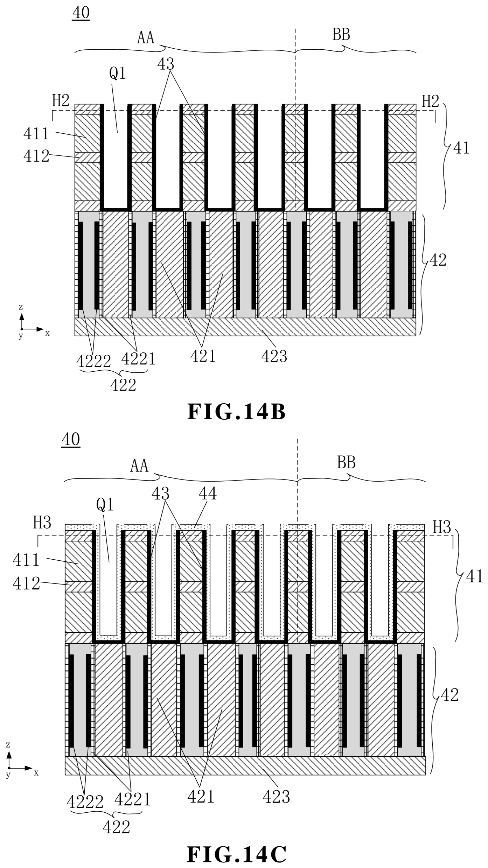

With continued reference to FIGs. 14A, 14B and 15B, FIG. 15B is a schematic cross-sectional structure view along an H2-H2 line in FIG. 14B. A material of the first electrode layer 43 includes a conductive material such as a metal or a metal compound, for example, tungsten, copper, titanium nitride (TiN), etc. First, a layer of conductive material may be formed on a side of the first stack layer 41. Thereafter, the conductive material outside the capacitor holes Q1 is removed by etching to form the first electrode layer 43 within the capacitor holes Q1.

It is to be noted that, since the capacitor holes Q1 are disposed as being spaced apart in the first region AA and the second region BB, interior portions of the first electrode layer 43 in the first region AA and interior portions of the first electrode layer 43 in the second region BB are also disposed as being spaced apart, that is, the first electrode layer 43 in the first region AA and the first electrode layer 43 in the second region BB each comprises a plurality of partitioned portions that are not connected with each other.

Operation S303: forming a dielectric layer 44 on a side of the first stack layer 41 in the first region AA and the second region BB, wherein the dielectric layer 44 covers a side of the first electrode layer 43 facing away from the inner walls of the capacitor holes Q1.

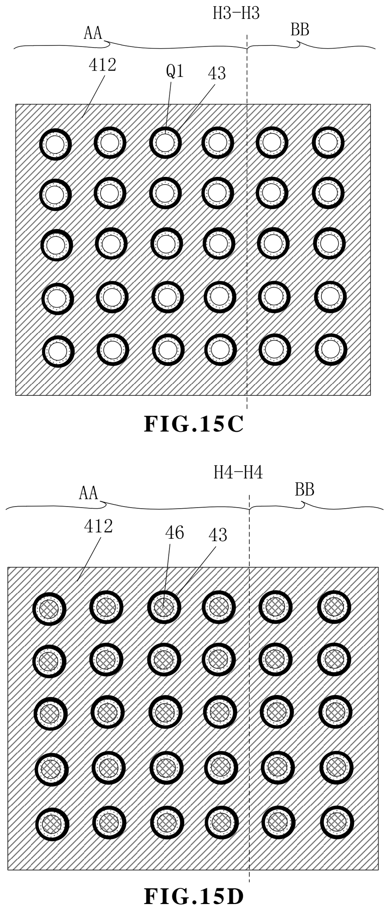

With continued reference to FIGs. 14B, 14C and 15C, FIG. 15C is a schematic cross-sectional structure view along an H3-H3 line in FIG. 14C. A material of the dielectric layer 44 includes a material with a high dielectric constant, and the dielectric layer 44 may be formed using a thin film deposition process. The dielectric layer 44 not only covers the first electrode layer 43 in the capacitor holes Q1, but also covers a top surface of the first stack layer 41.

Operation S304: forming a second electrode layer 45 on a side of the dielectric layer 44 in the first region AA facing away from the first electrode layers 43.

A material of the second electrode layer 45 mainly includes a conductive material, which may be selected from any one or any combination of tungsten, cobalt, copper, aluminum, or polysilicon, and doped crystalline silicon. The second electrode layer 45 is only located in the first region AA.

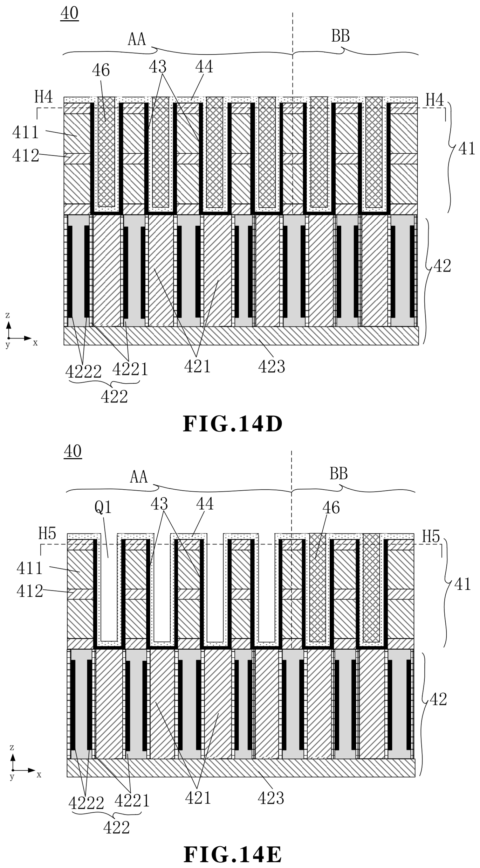

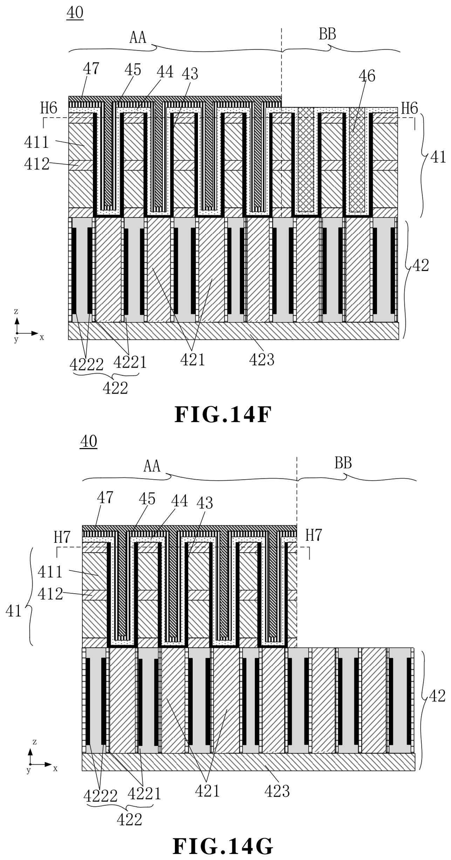

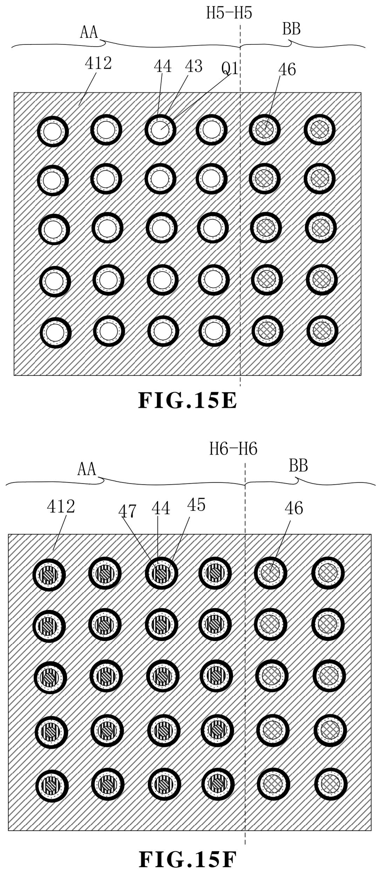

In some implementations, in order to ensure that the second electrode layer 45 is only formed in the first region AA, before the formation of the second electrode layer 45, the capacitor holes Q1 in the second region BB need to be fully filled first. With continued reference to FIGs. 14C to 14F, and 15D to 15F, FIG. 15D is a schematic cross-sectional structure view along an H4-H4 line in FIG. 14D, FIG. 15E is a schematic cross-sectional structure view along an H5-H5 line in FIG. 14E, and FIG. 15F is a schematic cross-sectional structure view along an H6-H6 line in FIG. 14F. Before the above operation S304, the fabrication method further comprises:
forming a filling layer 46 within the capacitor holes Q1 in the first region AA and the second region BB, wherein the filling layer 46 covers a side of the dielectric layer 44 facing away from the first electrode layer 43; and
removing the filling layer 46 in the first region AA, and exposing the dielectric layer 44 in the first region AA.

A material of the filling layer 46 may include an oxide, such as silicon dioxide. First, the filling layer 46 may be formed on a side of the first stack layer 41 through a thin film deposition process. At this point, the filling layer 46 may fully fill the capacitor holes Q1. Thereafter, the filling layer 46 outside the capacitor holes Q1 in the first region AA and the second region BB is removed, with only the filling layer 46 within the capacitor holes Q1 being remained. Thereafter, the second region BB is covered by a mask, and the filling layer 46 in the first region AA is removed. At this point, the dielectric layer 44 within the capacitor holes Q1 in the first region AA is exposed again. At this point, the above operation S304 comprises: forming the second electrode layer 45 on a side of the exposed dielectric layer 44 in the first region facing away from the first electrode layer 43.

In some implementations, after the formation of the second electrode layer 45, voids may remain in the capacitor holes Q1 and need to be fully filled, that is, with continued reference to FIGs. 14E and 14F, the fabrication method further comprises:
forming a semiconductor layer 47 on a side of the second electrode layer 45 in the first region AA facing away from the dielectric layer 44, wherein the semiconductor layer 47 fills the capacitor holes Q1 in the first region AA.

A material of the semiconductor layer 47 includes a semiconductor material, such as at least one of polysilicon or silicide (such as, silicon germanium SiGe), etc. The semiconductor layer 47 is located on top of the first stack layer 41 in the first region AA (on the second electrode layer 45 at the top), and within the capacitor holes Q1 in the first region AA (on the second electrode layer 45 in the capacitor holes Q 1).

Operation S305: removing the first stack layer 41, the dielectric layer 44 and the first electrode layer 43 in the second region BB.

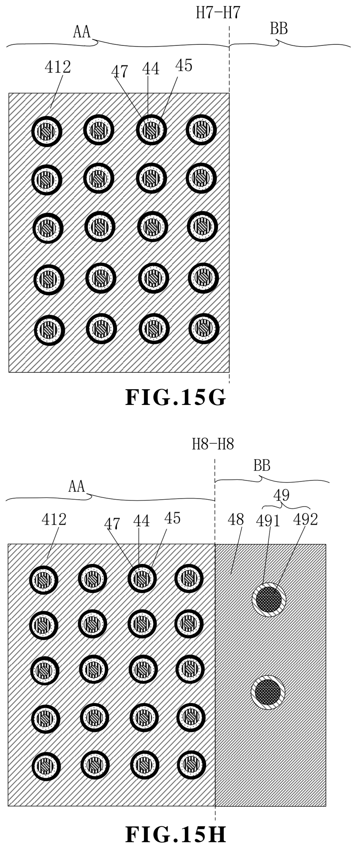

With continued reference to FIGs. 14F, 14G and 15G, FIG. 15G is a schematic cross-sectional structure view along an H7-H7 line in FIG. 14G. Various film layers in the second region BB may be removed by dry etching. In addition to the removal of the above-mentioned first stack layer 41, dielectric layer 44 and first electrode layer 43, the fabrication method further comprises: removing the filling layer 46 in the second region BB.

Operation S306: forming a planar layer 48 in the second region BB.

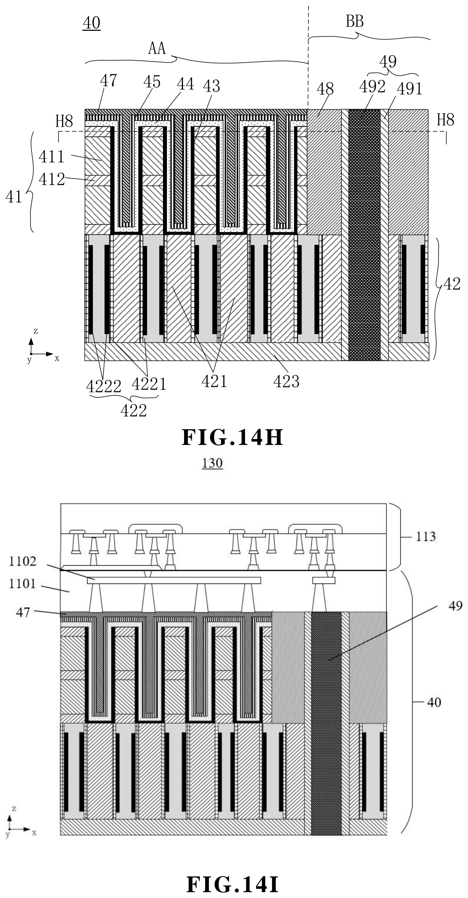

With continued reference to FIGs. 14G, 14H and 15H, FIG. 15H is a schematic cross-sectional structure view along an H8-H8 line in FIG. 14H. A material of the planar layer 48 may include an oxide, for example, silicon dioxide. The planar layer 48 may be processed through CMP (chemical mechanical polishing), to make a top surface of the planar layer 48 be approximately flush with a top surface of the second electrode layer 45 in the first region AA.

Operation S307: forming a contact structure 49 penetrating through the planar layer 48 along the stacking direction z.

With continued reference to FIGs. 14H and 15H, the contact structure 49 may be located in any position in the second region BB. The specific number of the contact structure 49 and its formation position in the second region BB may be determined according to actual requirements, which is not limited here. The contact structure 49 may comprise an insulation layer 491, and a conductive layer 492 on a side of the insulation layer 491 facing away from the first stack layer 41. A material of the insulation layer 491 includes an insulation material such as silicon oxide, etc., and a material of the conductive layer 492 includes a metal material such as tungsten, etc. The contact structure 49 not only penetrates through the planar layer 48, but also further penetrates through the second stack structure 42 along the stacking direction z and is connected with a peripheral circuit.

Examples of the present application further provide a semiconductor structure 40, with continued reference to FIGs. 14H, 15H and 15I above.

The semiconductor structure 40 comprises a second stack structure 42, a first stack layer 41 and a capacitor structure, wherein the capacitor structure is located within the first stack layer 41, and the first stack layer 41 is located on the second stack structure 42 and comprises a first region AA and a second region BB. The second stack structure 42 comprises a plurality of channel structures 421 disposed as being spaced apart along a first direction x and a second direction y, and gate structures 422 extending along the second direction y and connected with the plurality of channel structures 421. Each of the gate structure 422 is located between two adjacent ones of the channel structures 421. The first region AA of the first stack layer 41 has capacitor holes Q1 disposed as being spaced apart, and positions of the channel structures 421 correspond to positions of the capacitor holes Q1 in the first region AA. The gate structure 422 may comprise a gate spacing layer 4221 and a gate layer 4222. The gate spacing layer 4221 is located between the gate layer 4222 and the channel structure 421. Adjacent ones of the gate structures 422 are isolated and electrically insulated through an insulation material. The second stack structure 42 further comprises a bit line 423 that is located on a side of the second stack structure 42 away from the first stack layer 41 and is connected with the channel structures 421.

The first stack layer 41 comprises sacrificial layers 411 and spacing layers 412 that are disposed alternately, wherein the spacing layers are each located at an end of the second stack structure 42 away from the bit line 423, and the capacitor holes Q1 penetrate through the sacrificial layers 411 and the spacing layers 412. A material of the sacrificial layers 411 may include silicon dioxide, and a material of the spacing layers 412 may include silicon nitride.

The capacitor structure further comprises a first electrode layer 43, a dielectric layer 44, a second electrode layer 45 and a semiconductor layer 47, wherein the first electrode layer 43 is located on inner walls of the capacitor holes Q1 in the first region AA, and the first electrode layer 43, the sacrificial layers 411 and the spacing layers 412 in the first region AA each comprises a plurality of partitioned portions that are not connected with each other. The dielectric layer 44 is located on a side of the first stack layer 41 in the first region AA and covers a side of the first electrode layer 43 facing away from the inner walls of the capacitor holes Q1. The second electrode layer 45 is located on a side of the dielectric layer 44 in the first region AA facing away from the first electrode layer 43. The semiconductor layer 47 is located on a side of the second electrode layer 45 in the first region AA facing away from the dielectric layer 44 and fills the capacitor holes Q1 in the first region AA. That is, the first electrode layer 43 is disposed around the dielectric layer 44, the dielectric layer 44 is disposed around the second electrode layer 45, and the second electrode layer 45 is disposed around the semiconductor layer 47. The semiconductor layer 47 is connected with the second electrode layer 45 and is used to fill the capacitor holes Q1 and serves as a leading-out electrode of the capacitor structure. Since the first electrode layer 43 is disposed as being spaced apart, a plurality of capacitor structures disposed as being spaced apart and having a uniform size are formed in the first region AA.

The semiconductor structure 40 further comprises a planar layer 48 in the second region BB, wherein the planar layer 48 is disposed adjacent to the first stack layer 41 in the first region AA and located on a side of the second stack structure 42 away from the bit line 423.

The semiconductor structure 40 further comprises a contact structure 49 penetrating through the planar layer 48 along the stacking direction z. The contact structure 49 may comprise an insulation layer 491, and a conductive layer 492 on a side of the insulation layer 491 facing away from the first stack layer 41. A material of the insulation layer 491 includes an insulation material such as silicon oxide, etc., and a material of the conductive layer 492 includes a metal material such as tungsten, etc. The contact structure 49 not only penetrates through the planar layer 48, but also further penetrates through the second stack structure 42 along the stacking direction z and is connected with a peripheral circuit.

The semiconductor structure 40 further comprises an interconnection dielectric layer 1101 and an interconnection circuit layer 1102 that is within the interconnection dielectric layer 1101 and connected with the semiconductor layer 47.

As can be seen from above, according to the fabrication method of the semiconductor structure 40 provided by the examples of the present application, the plurality of capacitor holes Q1 penetrating through the first stack layer 41 along the stacking direction z are formed, the first stack layer 41 comprises the first region AA and the second region BB, and the capacitor holes Q1 are located in the first region AA and the second region BB, such that a serious etch loading effect can be greatly avoided in the first region AA during the formation of the capacitor holes Q1, the size consistency of the capacitor holes Q1 in the first region AA is ensured as much as possible, and under-etching will not occur. Subsequently, the first electrode layer 43 is formed on the inner walls of the capacitor holes Q1; the dielectric layer 44 is formed on a side of the first stack layer 41 in the first region AA and the second region BB, and covers the side of the first electrode layer 43 facing away from the inner walls of the capacitor holes Q1; the second electrode layer 45 is formed on the side of the dielectric layer 44 in the first region AA facing away from the first electrode layer 43; the first stack layer 41, the dielectric layer 44 and the first electrode layer 43 in the second region BB are removed; the planar layer 48 is formed in the second region BB; and the contact structure 49 penetrating through the planar layer 48 along the stacking direction z is formed, such that the capacitor structures with a uniform size can be formed in the first region AA, thus improving reliability of the capacitor structures.

Referring to FIGs. 7F, 11F and 14I, FIG. 7F is a schematic structure view of an example memory 110 provided by examples of the present application. FIG. 11F is a schematic structure view of an example memory 120 provided by examples of the present application. FIG. 14I is a schematic structure view of an example memory 130 provided by examples of the present application.

The memory 110/120/130 comprises the above-mentioned semiconductor structure 10/30/40 and a peripheral circuit structure 113, wherein the peripheral circuit structure 113 is located on a side of the interconnection dielectric layer 1101 of the semiconductor structure 10/30/40 facing away from a first stack layer 11 and is connected with the semiconductor structure 10/30/40 by bonding. In an example, the peripheral circuit structure 113 is connected with the interconnection circuit layer 1102 of the semiconductor structure 10/30/40.

In some implementations, the peripheral circuit structure 113 may further comprise a word line driver, a bit line driver, a column decoder, a sense circuit, a data buffer, a program verify logic and an erasing verification circuit, etc., which can perform the above operations according to obtained computer program instructions.

It is to be noted that, the peripheral circuit structure 113 and the semiconductor structure 10/30/40 may be disposed in a stack, or may be disposed as being spread out, which is not limited here.

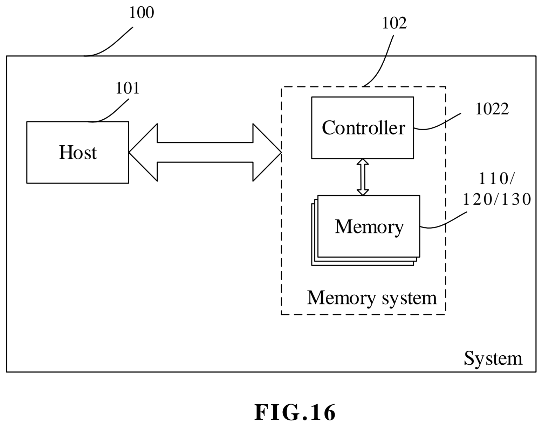

In addition, referring to FIG. 16, FIG. 16 is a schematic structure view of an example system 100 provided by examples of the present application. The system 100 may be a mobile phone, a desktop computer, a laptop computer, a tablet computer, a vehicle computer, a gaming console, a printer, a positioning apparatus, a wearable electronic apparatus, a smart sensor, a virtual reality (VR) apparatus, an augmented reality (AR) apparatus, or any other suitable electronic apparatuses having memories therein. As shown in FIG. 16, the system 100 may comprise a host 101 and a memory system 102, wherein the memory system 102 comprises one or more memories 110/120/130 and a controller 1022. The host 101 may be a processor (e.g., a central processing unit (CPU)) or a system on chip (SOC) (e.g., an application processor (AP)) of an electronic apparatus. The host 101 may be configured to send or receive data to or from the memory 110/120/130.

In the examples of the present application, the memory 110/120/130 is not limited to a three-dimensional DRAM memory. Without departing from the disclosure or teachings of the present application, the memory 110/120/130 may be also other various types of volatile memories (such as voltage-dependent data memories, etc.) as temporary storage media (also called system memories) of an operating system or other running programs.

In some implementations, the controller 1022 is coupled to the memory 110/120/130 and the host 101, and configured to control the memory 110/120/130, for example, to control the memory 110/120/130 to perform data writing and reading operations. The controller 1022 can manage the data stored in the memory 110/120/130 and communicate with the host 101.

The controller 1022 may be configured to control operations of the memory 110/120/130, such as reading, erasing, and programming operations. The controller 1022 may be further configured to manage various functions with respect to data stored or to be stored in the memory 110/120/130, including, but not limited to, bad-block management, garbage collection, logical-to-physical address conversion, wear leveling, etc.

The controller 1022 and one or more memories 110/120/130 can be integrated into various types of storage devices, for example, be included in the same package, such as a Universal Flash Storage (UFS) package or an eMMC package. That is to say, the memory system 102 can be implemented and be packaged into different types of electronic products.

The above descriptions are only examples of the present application, and are not intended to limit the present application. Any amendments, equivalent substitutions, improvements and the like made within the spirit and principle of the present application shall be encompassed within the protection scope of the present application.

## Claims

1. A fabrication method of a semiconductor structure, comprising:
forming a plurality of capacitor holes penetrating through a first stack layer along a stacking direction, wherein the first stack layer comprises a first region and a second region, and the capacitor holes are located in the first region and the second region;
forming a first electrode layer on inner walls of the capacitor holes;
forming a dielectric layer in the first region and the second region;
forming a second electrode layer on a side of the dielectric layer facing away from the first stack layer;
removing the second electrode layer on the first stack layer in the second region; and
forming a contact structure penetrating through the first stack layer in the second region along the stacking direction.

2. The fabrication method of the semiconductor structure of claim 1, wherein the first stack layer comprises sacrificial layers, and the fabrication method further comprises:
forming a filling layer on a side of the first electrode layer facing away from the inner walls of the capacitor holes, wherein the filling layer fills the capacitor holes; and
forming a plurality of spacing holes penetrating through part of the first stack layer along the stacking direction, and removing the sacrificial layers to form first empty slots, wherein the spacing holes are located in the first region and the second region.

3. The fabrication method of the semiconductor structure of claim 2, wherein the forming the dielectric layer in the first region and the second region comprises:
forming the dielectric layer on a side of the first stack layer in the first region and the second region, with the dielectric layer covering inner walls of the first empty slots and inner walls of the spacing holes,
wherein the second electrode layer is located in the first empty slots and the spacing holes.

4. The fabrication method of the semiconductor structure of claim 3, wherein the forming the plurality of spacing holes penetrating through part of the first stack layer along the stacking direction and removing the sacrificial layers to form the first empty slots further comprises:
removing the filling layer to form second empty slots,
wherein the dielectric layer and the second electrode layer are also located in the second empty slots.

5. The fabrication method of the semiconductor structure of claim 1, wherein the forming the dielectric layer in the first region and the second region comprises:
forming the dielectric layer on a side of the first stack layer in the first region and the second region, with the dielectric layer covering a side of the first electrode layer facing away from the inner walls of the capacitor holes,
wherein the second electrode layer is located in the capacitor holes.

6. The fabrication method of the semiconductor structure of claim 5, further comprising:
forming a semiconductor layer on a side of the second electrode layer in the first region and the second region facing away from the dielectric layer, wherein the semiconductor layer fills the capacitor holes; and
the removing the second electrode layer on the first stack layer in the second region further comprises: removing the semiconductor layer on the first stack layer in the second region.

7. The fabrication method of the semiconductor structure of any one of claims 1-6, further comprising:
forming a second stack structure, wherein the second stack structure comprises a plurality of channel structures disposed as being spaced apart along a first direction and a second direction and gate structures that extend along the second direction and are connected with the plurality of channel structures, each of the gate structures is located between two adjacent ones of the channel structures, and the first direction x, the second direction y and the stacking direction z are perpendicular to one another; and
forming the first stack layer on the second stack structure,
wherein positions of the channel structures at least correspond to positions of the capacitor holes in the first region.

8. The fabrication method of the semiconductor structure of claim 7, wherein the positions of the channel structures also correspond to positions of the capacitor holes in the second region, and positions of the gate structures at least correspond to the first region.

9. A fabrication method of a semiconductor structure, comprising:
forming a plurality of capacitor holes penetrating through a first stack layer along a stacking direction, wherein the first stack layer comprises a first region and a second region, and the capacitor holes are located in the first region and the second region;
forming a first electrode layer on inner walls of the capacitor holes in the first region;
removing part of the first stack layer in the first region and the second region;
forming a dielectric layer and a second electrode layer in the first region, wherein the second electrode layer is located on a side of the dielectric layer facing away from the first electrode layer;
forming a planar layer in the second region; and
forming a contact structure penetrating through the planar layer along the stacking direction.

10. The fabrication method of the semiconductor structure of claim 9, wherein the forming the dielectric layer and the second electrode layer in the first region comprises:
forming the dielectric layer on a side of the first stack layer in the first region and the second region;
forming the second electrode layer on a side of the dielectric layer facing away from the first stack layer; and
removing the dielectric layer and the second electrode layer in the second region.

11. The fabrication method of the semiconductor structure of claim 9, wherein before forming the first electrode layer on the inner walls of the capacitor holes in the first region, the fabrication method further comprises:
forming sacrificial structures in the capacitor holes in the first region and the second region; and
removing the sacrificial structures in the first region, and exposing the capacitor holes in the first region; and
the forming the first electrode layer on the inner walls of the capacitor holes in the first region comprises: forming the first electrode layer on the inner walls of the exposed capacitor holes.

12. The fabrication method of the semiconductor structure of claim 11, wherein the first stack layer comprises sacrificial layers, and the removing part of the first stack layer in the first region and the second region comprises:
forming a plurality of spacing holes penetrating through part of the first stack layer in the first region along the stacking direction, and removing the sacrificial layers to form first empty slots; and
removing the sacrificial structures in the second region,
wherein the dielectric layer and the second electrode layer fill the spacing holes and the first empty slots.

13. The fabrication method of the semiconductor structure of claim 9, further comprising:
forming a filling layer on a side of the first stack layer in the first region and the second region, wherein the filling layer covers a side of the first electrode layer in the first region facing away from the inner walls of the capacitor holes and fills the capacitor holes in the first region.

14. The fabrication method of the semiconductor structure of claim 13, wherein the removing part of the first stack layer in the first region and the second region further comprises:
removing the filling layer within the capacitor holes in the first region to form second empty slots,
wherein the dielectric layer and the second electrode layer also fill the second empty slots.

15. The fabrication method of the semiconductor structure of any one of claims 9-14, further comprising:
forming a second stack structure, wherein the second stack structure comprises a plurality of channel structures disposed as being spaced apart along a first direction and a second direction and gate structures that extend along the second direction and are connected with the plurality of channel structures, each of the gate structures is located between two adjacent ones of the channel structures, and the first direction x, the second direction y and the stacking direction z are perpendicular to one another; and
forming the first stack layer on the second stack structure,
wherein positions of the channel structures at least correspond to positions of the capacitor holes in the first region.

16. The fabrication method of the semiconductor structure of claim 15, wherein the positions of the channel structures also correspond to positions of the capacitor holes in the second region, and positions of the gate structures at least correspond to the first region.

17. A fabrication method of a semiconductor structure, comprising:
forming a plurality of capacitor holes penetrating through a first stack layer along a stacking direction, wherein the first stack layer comprises a first region and a second region, and the capacitor holes are located in the first region and the second region;
forming a first electrode layer on inner walls of the capacitor holes in the first region and the second region;
forming a dielectric layer on a side of the first stack layer in the first region and the second region, wherein the dielectric layer covers a side of the first electrode layer facing away from the inner walls of the capacitor holes;
forming a second electrode layer on a side of the dielectric layer in the first region facing away from the first electrode layer;
removing the first stack layer, the dielectric layer and the first electrode layer in the second region;
forming a planar layer in the second region; and
forming a contact structure penetrating through the planar layer along the stacking direction.

18. The fabrication method of the semiconductor structure of claim 17, further comprising:
forming a filling layer within the capacitor holes in the first region and the second region, wherein the filling layer covers a side of the dielectric layer facing away from the first electrode layer;
removing the filling layer in the first region, and exposing the dielectric layer in the first region; and
the forming the second electrode layer on the side of the dielectric layer in the first region facing away from the first electrode layer comprises: forming the second electrode layer on the side of the exposed dielectric layer in the first region facing away from the first electrode layer.

19. The fabrication method of the semiconductor structure of claim 18, wherein the removing the first stack layer, the dielectric layer and the first electrode layer in the second region further comprises:
removing the filling layer in the second region.

20. The fabrication method of the semiconductor structure of claim 18, further comprising:
forming a semiconductor layer on a side of the second electrode layer in the first region facing away from the dielectric layer, wherein the semiconductor layer fills the capacitor holes in the first region.

21. The fabrication method of the semiconductor structure of any one of claims 17-20, further comprising:
forming a second stack structure, wherein the second stack structure comprises a plurality of channel structures disposed as being spaced apart along a first direction and a second direction and gate structures that extend along the second direction and are connected with the plurality of channel structures, each of the gate structures is located between two adjacent ones of the channel structures, and the first direction x, the second direction y and the stacking direction z are perpendicular to one another; and
forming the first stack layer on the second stack structure,
wherein positions of the channel structures at least correspond to positions of the capacitor holes in the first region.

22. The fabrication method of the semiconductor structure of claim 21, wherein the positions of the channel structures also correspond to positions of the capacitor holes in the second region, and positions of the gate structures at least correspond to the first region.

23. A semiconductor structure, comprising:
a first stack structure comprising a first region and a second region;
a first electrode layer in the first region and the second region, wherein the first electrode layer penetrates through the first stack structure along a stacking direction, and the first electrode layer in the first region and the first electrode layer in the second region are disposed as being spaced apart;
a dielectric layer in the first region and the second region;
a second electrode layer in the first region and the second region, wherein the dielectric layer is disposed between the first electrode layer and the second electrode layer, and the second electrode layer in the first region and the second electrode layer in the second region are disposed as being spaced apart; and
a contact structure penetrating through the first stack structure in the second region along the stacking direction.

24. The semiconductor structure of claim 23, wherein interior portions of the first electrode layer in the first region and the second region are both disposed as being spaced apart along a first direction and a second direction, and the first direction x, the second direction y and the stacking direction z are perpendicular to one another.

25. The semiconductor structure of claim 23, wherein the dielectric layer is located on a side of the first stack structure and penetrates through part of the first stack structure in the first region and the second region along the stacking direction; and the second electrode layer is located on the first stack structure in the first region and covers a side of the dielectric layer within the first stack structure facing away from the first electrode layer.

26. The semiconductor structure of claim 25, wherein the dielectric layer within the first stack structure covers a side of the first electrode layer in the first region and the second region facing away from the first stack structure.

27. The semiconductor structure of claim 26, further comprising: a semiconductor layer, wherein the semiconductor layer is located on the first stack structure in the first region and covers a side of the second electrode layer within the first stack structure in the first region and the second region facing away from the dielectric layer.

28. The semiconductor structure of claim 25, wherein the dielectric layer within the first stack structure is at least located between two adjacent portions of the first electrode layer that are disposed as being spaced apart.

29. The semiconductor structure of claim 28, further comprising: a filling layer within the first stack structure in the first region and the second region, wherein interior portions of the filling layer are disposed as being spaced apart, and the first electrode layer is disposed around the filling layer.

30. The semiconductor structure of claim 28, wherein the dielectric layer within the first stack structure further covers a side of the first electrode layer facing away from the first stack structure.

31. The semiconductor structure of claim 25, wherein the first stack structure comprises a plurality of spacing layers disposed in decks, wherein the dielectric layer and the second electrode layer are also located between two adjacent ones of the spacing layers along the stacking direction in the first region and the second region.

32. The semiconductor structure of any one of claims 24-31, further comprising: a second stack structure, wherein the second stack structure is located on a side of the first stack structure facing away from the second electrode layer and comprises a plurality of channel structures disposed as being spaced apart along the first direction and the second direction and gate structures that extend along the second direction and connect with the plurality of channel structures, and each of the gate structure is located two adjacent ones of the channel structures,
wherein positions of the channel structures at least correspond to a position of the first electrode layer in the first region, and the contact structure penetrates through the first stack structure and the second stack structure along the stacking direction.

33. The semiconductor structure of claim 32, wherein the positions of the channel structures also correspond to a position of the first electrode layer in the second region, and positions of the gate structures at least correspond to the first region.

34. A memory, comprising: the semiconductor structure of any one of claims 23-33, and a peripheral circuit structure, wherein the peripheral circuit structure is connected with the semiconductor structure.

35. A memory system, comprising: at least one memory of claim 34, and a controller coupled with the memory and configured to control the memory to store data.
